# EUROPEAN PATENT APPLICATION

(11) **EP 3 422 023 A1**
(43) Date of publication of application: **02.01.2019**
(21) Application number: 17756690.8
(22) Date of filing: 27.02.2017
(51) Int. Cl.: G01R 15/18, G01R 1/22, H01F 38/28, H01F 38/30

(54) **CURRENT TRANSFORMER**

(30) Priority: 26.02.2016 JP 2016035292
(71) Applicant: Dyden Corporation, Kurume-shi, Fukuoka 830-8511 (JP)
(72) Inventor: KURANAGA Yuji, Kurume-shi Fukuoka 830-8511 (JP); ODA Hidenori, Kurume-shi Fukuoka 830-8511 (JP); TERASAKI Koji, Kurume-shi Fukuoka 830-8511 (JP); KODAMA Seiju, Kurume-shi Fukuoka 830-8511 (JP)
(74) Representative: HGF Limited
(86) International application number: PCT/JP2017/007539
(87) International publication number: WO 2017/146256

(57) **Abstract**

There is provided a current transformer that a connecting mechanism by which cores can be opened or closed, a water-proof property can be achieved by a simple structure.

A pair of divided cores (11, 12), which are openably and closably connected to each other by means of a hinge member (15), are closed in a ring-shape by inserting ends of the divided cores into connecting members (17) having a tube shape, and sealing bodies (18) provides a sealing performance between the connecting members (17) and the outer cover body (14) at the ends of the divided cores. It is therefore possible to ensure easily a water-proof state by bringing the sealing body (18) into contact with the connection members (17) and the outer cover body (14), and simplify the respective structures for providing a water-proof performance, thus making it possible to reduce a size and weight of the current transformer.

## Description

### [TECHNICAL FIELD]

The present invention relates to a clamp-type current transformer that can be used by putting a pair of divided cores, which is openable and closable, around an existing electric wire or cable, and especially to a current transformer having a structure by which a water proof property at abutting ends of the divided cores.

### [BACKGROUND ART]

There has conventionally been used a current transformer (CT) for measuring an electric current of a conductive line such as an electric feeder or distribution line, through which an alternating electric current. Such a current transformer has a configuration in which coils are wound around a ring-shaped iron core (core) so as to appropriately convert a value of a primary current of the electric wire passing through a hole at a center of the core into a lower value to create an electric current corresponding to a primary current at a secondary coil.

In case where such a current transformer is used for an existing electric feeder or distribution line, there has generally been use a split-type current transformer having a structure in which a pair of divided cores can be joined into a ring-shape, thus making it easy to provide a state where even an electric feeder or distribution line as already laid passes through the core.

However, an electric feeder or distribution line is used in an outdoor or underground environment in which contact with water is unavoidable. If a current transformer is used for an electric feeder or distribution line, it is therefore necessary to isolate cores and coils of the current transformer from water, as a structure of sealing the cores and coils of the current transformer from outside, to prevent deterioration of the iron cores and coils, and to secure insulation of an electric circuit.

A split-type current transformer having a water-proof structure has conventionally been proposed, and an example of such a current transformer is disclosed in JP 2010-243312 A.

### [CITATION LIST]

### [Patent Literature]

[PTL 1] JP 2010-243312 A
[PTL 2] JP 2001-297921 A

### [SUMMARY OF INVENTION]

### [Technical Problem]

Of the conventional split-type current transformers disclosed in the above-identified patent documents, the current transformer disclosed in PTL 1 has a structure in which plate members of ferrite having a water-resistant property are placed on edges of two cores in order to insulate joined portions of the cores to prevent water or the like from penetrating inside, so as to keep a distance from an outer surface to a silicon steel portion and a coil-wound portion of the cores to ensure a sufficient water-proof property and an insulating capacity, thus inhibiting occurrence of failure even in a water adhesion.

However, there is a problem that, in case where ferrite having a small saturation flux density in a low-frequency region is used as a material for the ends, serving as a joining portion, of the cores, a large cross-sectional area of the ferrite member, i.e., a larger area of the end of the ferrite (the joining surface) is required to ensure performance, and accordingly, the size of the current transformer is compelled to become larger.

In addition, there is another problem that, in case where the ferrite is used for the cores of the current transformer, the ferrite has a small saturation flux density in a low-frequency region, with the result that a value of a primary electric current, which is permissible for the transformer, becomes small, thus subjecting to limitations of performance.

Further, such a conventional split-type current transformer with a water-proof structure is provided with a pair of cores, which are completely divided from each other. However, during an operation of fitting such a split-type current transformer to an electric feeder or distribution line or the like, an operator is compelled to hold the two independent cores with both hands, respectively, so as not to drop one of the two independent cores, and to do the joining and securing work, while keeping the cores in a proper positional relationship. In effect, there is a problem that it is difficult for a single operator to complete the fitting operation of the current transformer, and such an operation requires plural member of operators. There is also a further problem that a coil is often wound around only one core, in order to prevent a tension from being applied to a lead line from the coil, and in this case, a sufficient width of would coil cannot be ensured, leading to an increased number of layers of wound coil, and a large size of the current transformer.

On the other hand, with respect to a split-type current transformer disclosed in PTL 2, which is an opening-closing clamp-type having a connection structure by which a pair of cores may be opened and closed, it is easy to hold the two cores even in a operation condition such as a fitting operation to an electric feeder or distribution line or the like, and a size of the current transformer may be reduced by winding coils around the respective cores, thus providing an excellent handling property. However, a structure for bringing the corresponding edges of the cores into close contact with each other is complicated, thus making it difficult to ensure a water-proof property, with the result that it has conventionally been hard to apply such a transformer to use in a place such as an outdoor or underground environment where there is a high possibility of contact with water.

An object of the present invention, which has been made to solve the above-described problems, is to provide a current transformer that a connecting mechanism by which cores can be opened or closed, a water-proof property can be achieved by a simple structure, a size and weight of the whole of the transformer may be reduced, it is easy to provide the transformer around an electric feeder or distribution line as already laid, and it is easy to remove the transformer if it becomes unnecessary.

### [Solution to Problem]

A current transformer according to the present invention comprises a pair of divided cores having a shape of two halves into which a continuous substantially ring-shaped body is divided, a coil wound around one or both of the divided cores, and a hinge member that connects the pair of divided cores so as to be openable and closable, the current transformer being detachably put around an electric wire or cable so that the electric wire or cable passes through a bore portion, which is formed at a center of the pair of divided cores kept in a closed state into a substantially ring-shape, the current transformer further comprises: an outer cover body that covers an outer peripheral portion, excepting opposite ends of each of the pair of the divided cores, which face each other, and the coil to insulate them from outside, the outer cover body being formed of material having a waterproof property and an insulation property; two connecting members each formed as a tube body, into which corresponding one ends of the divided cores and other ends of them are to be inserted detachably to connect them with each other; and a sealing body being formed of elastic material into a ring-shape, the sealing body being provided on the connecting members or the outer cover body, in a state where the ends of each of the divided cores are inserted into the connecting members, respectively, so as to be placed between an inner peripheral portion of the connecting member and an outer peripheral portion of an end of the outer cover body, which is inserted into the connecting member to be placed inside of the connecting member, or between an outer peripheral portion of the connecting member and an inner peripheral portion of the end of the outer cover body having a tube shape into which the end of the connecting member is inserted to be placed outside of the connecting member; wherein: ends of the outer cover body in a vicinity of the opposite ends of the divided core have a pillar shape having an outer shape, which is similar to a cross-sectional shape of an opening of an inside of the tube body of the connecting member into which the end portion of the divided core is to be inserted, or have a tube shape having an opening shape, which is similar to a cross-sectional shape of an outer tube shape of the connecting member into which the end portion of the divided core is to be inserted; both ends having the pillar shape or the tube shape of the outer cover body are shaped so that the pillar shape or the tube shape extend parallel with each other; the hinge member is connected to each of the divided cores so that the pair of divided cores cause extending directions of the ends of the outer cover body to align to permit a linear relative movement in which the pair of divided cores come close to each other or go away from each other; and the ends of the each of the divided cores are inserted into each of the connecting members in a state where the pair of divided cores are closed in a substantial ring-shape, and in such a closed state the ends of the divided cores come into contact with each other and the sealing body come into close contact with each of the connecting members and the outer cover body without creating a gap between them, with elastic deformation of the sealing body.

According to the present invention, the pair of divided cores, which are openably and closably connected to each other by means of the hinge member, are closed in a ring-shape by inserting the ends of the respective divided cores into the connecting members having a tube shape, and the pillar portions of the outer cover body at the ends of the divided cores are detachably inserted into the inside of the connecting members having the tube shape, or the connecting members are detachably inserted into the inside of the tube portions of the outer cover body at the ends of the divided cores so that the sealing body having the ring-shape provides a sealing performance between the inner surface of the tube portions of the connecting members and the outer surface of the pillar portions of the outer cover body, which surfaces face each other, or between the outer surface of the tube portions of the connecting members and the inner surface of the tube portions of the outer cover body, which surfaces face each other. It is therefore possible to ensure easily a water-proof state by bringing the sealing body into contact with the connection members and the outer cover body, with elastic deformation of the sealing body, and simplify the respective structures for providing a water-proof performance, thus making it possible to reduce a size and weight of the transformer and reduce a manufacturing cost.

Further, in addition to the feature that the end of the core is detachably inserted into the connecting member, movement of the divided cores only in a linear direction is permitted in a state where the end of the core is inserted into the connecting member by causing the pillar portion of the outer cover body to be detachably inserted into the connecting member or causing the connecting member to be detachably inserted into the inside of the tube portion of the outer cover body. Therefore, a water-tight state by the sealing body is still kept, unless the divided core moves relative to the connecting member to a position where the sealing body is shifted a region between the connecting member and the outer cover body, even if the connection of the divided core relative to the connecting member becomes loose, thus making it possible to maintain a water-proof performance, prevent deterioration of the core due to water, and secure insulation of an electric circuit. Further, permitting the pair of divided cores connected by the hinge member to move linearly and swing makes it possible to open and close the divided cores smoothly so as to place rapidly the current transformer on the outer side of an object such as an electric wire around which the current transformer is to be fitted, and to remove it from the object, thus improving an operation activity.

In other aspect, a current transformer according to the present invention comprises a pair of divided cores having a shape of two halves into which a continuous substantially ring-shaped body is divided, a coil wound around one or both of the divided cores, and a hinge member that connects the pair of divided cores so as to be openable and closable, the current transformer being detachably put around an electric wire or cable so that the electric wire or cable passes through a bore portion, which is formed at a center of the pair of divided cores kept in a closed state into a substantially ring-shape, the current transformer further comprises: an outer cover body that covers an outer peripheral portion, excepting opposite ends of each of the pair of the divided cores, which face each other, and the coil to insulate them from outside, the outer cover body being formed of material having a waterproof property and an insulation property; two connecting members provided on opposite ends of one of the divided cores, respectively, each of the two connecting members having a tube portion, one end of the other of the divided cores being inserted detachably into the tube portion of the one of the divided cores and other end of the other of the divided cores being inserted detachably into the other tube portion of the one of the divided cores, to connect them with each other; and a sealing body being formed of elastic material into a ring-shape, the sealing body being provided on the connecting members or the outer cover body, in a state where the ends of the other of the divided cores are inserted into the connecting members, respectively, so as to be placed between an inner peripheral portion of the connecting member and an outer peripheral portion of an end of the outer cover body, which is inserted into the connecting member to be placed inside of the connecting member, or between an outer peripheral portion of the connecting member and an inner peripheral portion of the end of the outer cover body having a tube shape into which the end of the connecting member is inserted to be placed outside of the connecting member; wherein: the two connecting members are provided so that each of the ends of the one of the divided cores is placed in the tube portion and the tube shape extend parallel with each other; ends of the outer cover body for the other of the divided cores in a vicinity of the opposite ends of the divided core have a pillar shape having an outer shape, which is similar to a cross-sectional shape of an opening of an inside of the tube body of the connecting member into which the end portion of the divided core is to be inserted, or have a tube shape having an opening shape, which is similar to a cross-sectional shape of an outer tube shape of the connecting member into which the end portion of the divided core is to be inserted; both ends having the pillar shape or the tube shape of the outer cover body for the other of the divided cores are shaped so that the pillar shape or the tube shape extend parallel with each other; the hinge member is connected to each of the divided cores so that the pair of divided cores cause extending directions of the connecting member and extending directions of the ends of the outer cover body to align to permit a linear relative movement in which the pair of divided cores come close to each other or go away from each other; and each of the ends of the other of the divided cores are inserted into each of the connecting members in a state where the pair of divided cores are closed in a substantial ring-shape, and in such a closed state the ends of the divided cores come into contact with each other and the sealing body come into close contact with each of the connecting members and the outer cover body without creating a gap between them, with elastic deformation of the sealing body.

According to the present invention, the pair of divided cores, which are openably and closably connected to each other by means of the hinge member, are closed in a ring-shape by inserting, into the tube portions of the connecting members at the opposite ends of one of the divided cores, the ends of the other divided core, and the pillar portions of the outer cover body at the ends of the other divided core are detachably inserted into the inside of the tube portions of the connecting members at the opposite ends of the divided core, or the connecting members are detachably inserted into the inside of the tube portions of the outer cover body at the ends of the divided cores so that the sealing body having the ring-shape provides a sealing performance between the inner surface of the tube portions of the connecting members and the outer surface of the pillar portions of the outer cover body, which surfaces face each other, or between the outer surface of the tube portions of the connecting members and the inner surface of the tube portions of the outer cover body, which surfaces face each other. It is therefore possible to ensure easily a water-proof state by bringing the sealing body into contact with the connection members and the outer cover body, with elastic deformation of the sealing body, and simplify the respective structures for providing a water-proof performance, thus making it possible to reduce a size and weight of the transformer and reduce a manufacturing cost.

Further, in addition to the feature that the connecting members at the ends of one of the divided cores can detachably receive the ends of the other divided cores, movement of the divided cores only in a linear direction is permitted in a state where the end of the core is inserted into the connecting member by causing the pillar portion of the outer cover body of the other divided core to be detachably inserted into the connecting member or causing the connecting member to be detachably inserted into the inside of the tube portion of the outer cover body. Therefore, a water-tight state by the sealing body is still kept, unless the end of the other divided core moves relative to the connecting member of the one divided core to a position where the sealing body is shifted a region between the connecting member and the outer cover body, even if the connection of the divided cores becomes loose, thus making it possible to maintain a water-proof performance, prevent deterioration of the core due to water, and secure insulation of an electric circuit.

In other aspect, a current transformer according to the present invention comprises a pair of divided cores having a shape of two halves into which a continuous substantially ring-shaped body is divided, a coil wound around one or both of the divided cores, and a hinge member that connects the pair of divided cores so as to be openable and closable, the current transformer being detachably put around an electric wire or cable so that the electric wire or cable passes through a bore portion, which is formed at a center of the pair of divided cores kept in a closed state into a substantially ring-shape, the current transformer further comprises: an outer cover body that covers an outer peripheral portion, excepting opposite ends of each of the pair of the divided cores, which face each other, and the coil to insulate them from outside, the outer cover body being formed of material having a waterproof property and an insulation property; two connecting members provided on one end of one of the divided cores and other end of the other of the divided cores, respectively, each of the two connecting members having tube portion, one end of the other of the divided cores being inserted detachably into the tube portion at the one end of one of the divided cores and other end of the other of the divided cores being inserted detachably into the other tube portion at the other end of the other of the divided cores, to connect them with each other; a sealing body being formed of elastic material into a ring-shape, the sealing body being provided on the connecting members or the outer cover body, in a state where the ends of each of the divided cores are inserted into the connecting members, respectively, so as to be placed between an inner peripheral portion of the connecting member and an outer peripheral portion of an end of the outer cover body, which is inserted into the connecting member to be placed inside of the connecting member, or between an outer peripheral portion of the connecting member and an inner peripheral portion of the end of the outer cover body having a tube shape into which the end of the connecting member is inserted to be placed outside of the connecting member; wherein: ends of the outer cover body for each of the divided cores in a vicinity of the end of the divided core on a side where the connecting member is not provided have a pillar shape having an outer shape, which is similar to a cross-sectional shape of an opening of an inside of the tube body of the connecting member into which the end portion of the divided core is to be inserted, or have a tube shape having an opening shape, which is similar to a cross-sectional shape of an outer tube shape of the connecting member into which the end portion of the divided core is to be inserted; ends having the pillar shape or the tube shape of the outer cover body for the divided cores are shaped so that the pillar shape or the tube shape extend parallel with the tube shape of the connecting member provided on a same divided core; the hinge member is connected to each of the divided cores so that the pair of divided cores cause extending directions of the connecting member and extending directions of the ends of the outer cover body to align to permit a linear relative movement in which the pair of divided cores come close to each other or go away from each other; and end of the other of the divided cores is inserted into the connecting members of each of the divided cores in a state where the pair of divided cores are closed in a substantial ring-shape, and in such a closed state the ends of the divided cores come into contact with each other and the sealing body come into close contact with each of the connecting members and the outer cover body without creating a gap between them, with elastic deformation of the sealing body.

According to the present invention, the pair of divided cores, which are openably and closably connected to each other by means of the hinge member, are closed in a ring-shape by inserting, into the tube portions of the connecting members at the opposite ends of one of the divided cores, the ends of the other divided core, and the pillar portions of the outer cover body at the ends of the divided core are detachably inserted into the inside of the connecting members having the tube shape, or the connecting members are detachably inserted into the inside of the tube portions of the outer cover body at the ends of the divided cores so that the sealing body having the ring-shape provides a sealing performance between the inner surface of the tube portions of the connecting members and the outer surface of the pillar portions of the outer cover body, which surfaces face each other, or between the outer surface of the tube portions of the connecting members and the inner surface of the tube portions of the outer cover body, which surfaces face each other. It is therefore possible to ensure easily a water-proof state by bringing the sealing body into contact with the connection members and the outer cover body, with elastic deformation of the sealing body, and simplify the respective structures for providing a water-proof performance, thus making it possible to reduce a size and weight of the transformer and reduce a manufacturing cost.

Further, in addition to the feature that the connecting members at the ends of one of the divided cores can detachably receive the ends of the other divided cores, movement of the divided cores only in a linear direction is permitted in a state where the end of the core is inserted into the connecting member by causing the pillar portion of the outer cover body to be detachably inserted into the connecting member or causing the connecting member to be detachably inserted into the inside of the tube portion of the outer cover body. Therefore, a water-tight state by the sealing body is still kept, unless the end of the divided core as inserted moves relative to the connecting member to a position where the sealing body is shifted a region between the connecting member and the outer cover body, even if the connection of the divided cores becomes loose, thus making it possible to maintain a water-proof performance, prevent deterioration of the core due to water, and secure insulation of an electric circuit.

The current transformer according to the present invention may have, where appropriate, a configuration in which the hinge member comprises a hinge member main body provided with a connection hole as an elongated hole having a predetermined length; and a supporting shaft, which is inserted into the connection hole so as to be movable in a longitudinal direction thereof and swingable, one or a plurality of sets of the connection hole and the supporting shaft being provided for the hinge member main body; and at least one divided core of the pair of divided cores and the hinge member are connected to each other so that the supporting shaft of the hinge member is connected to a predetermined position of the outer cover body, with which the divided core is covered, on a side of the end of the divided core, and the divided core connected to the supporting shaft is movable and swingable relative to the hinge member main body.

According to the present invention, the hinge member main body of the hinge member is provided with at least one connection hole, and the supporting shaft, which is inserted into the above-mentioned connection hole, is connected to a predetermined portion of the end of the outer cover body with which at least one of the divided cores is covered, and the supporting shaft and the divided core are joined together. The pair of divided cores can therefore be swingable relative to each other by causing the supporting shaft to roll within the connection hole of the hinge member, in a state where the divided cores are connected to each other by means of the hinge member, thus making it possible to easily change in state of the divided cores from one where the divided cores are opened to the other where the respective ends of the divided cores face squarely, and to achieve a smooth opening and closing operation when the divided cores are put around an electric wire or cable. In addition, movement of the supporting shaft within the connection hole as the elongated hole of the hinge member main body permits a linear relative movement of the divided cores so that insertion and removal between the end of the divided cores and the connecting member can be provided smoothly by moving the one divided core relative to the other divided core.

The current transformer according to the present invention may have, where appropriate, a configuration in which the outer cover body comprises an intermediate portion placed between the ends or the connecting members provided on the opposite ends in the pillar shape or the tube shape, the intermediate portion being separately formed from the ends or the connecting members provided on the opposite ends in the pillar shape or the tube shape, and the intermediate portion is formed through a resin molding after mounting parts for forming the ends or the connecting members provided on the opposite ends in the pillar shape or the tube shape to the opposite ends of the divided core.

According to the present invention, the end portion of the outer cover body or the connecting member, and the intermediate portion are formed separately from each other, and resin material for the above-mentioned intermediate portion is provided, through a mold formation, as the intermediate portion of the outer cover body, which cover the intermediate portion of the divided core and the coil would around it. It is therefore possible to provide the intermediate portion with a seamless covering structure as a united body, so that the outer cover member can protect the divided cores in a sealed state with a simple structure even at the other place than the edges of the divided cores to ensure an excellent water-proof property and prevent water from penetrating in the inside of the divided cores. As a result, many kinds of material excellent in magnetic property may be used for the divided cores, irrespective of a water-proof property. In addition, it is possible to maintain an insulation property even in an environment where contact of the transformer with water may occur, and there is no need to provide an additional water-proof structure for ensuring insulation property, thus permitting to reduce a size and weight of the divided cores and improve handling property of the whole transformer.

The current transformer according to the present invention may further comprise, where appropriate, a fastening member detachably provided in a vicinity of the divided cores so as to be capable of pressing the pair of divided cores to each other from outside in a direction in which the pair of divided cores come close to each other in a state where the ends of the divided cores are inserted together with the outer cover body into the connecting members to keep a closed state of the pair of divided cores in a substantially ring-shape, so as to keep a close contact state between the one ends of the pair of divided cores and between the other ends thereof.

According to the present invention, the ends of the pair of divided cores are kept in a close contact state by pressing, by means of the detachable fastening member, the pair of divided cores to each other from outside in a direction in which the pair of divided cores come close to each other. If the pair of divided cores is finally fit around an electric wire or cable, it is possible to continuously ensure a water-proof property on the ends of the cores by preventing the pair of divided cores from separating from each other by the fastening member. If the transformer becomes unnecessary, release of a fixed state by the fastening member makes it possible to remove easily the divided cores from the electric wire or the like, and the divided cores become completely free from the fastening member after removal of them, and the divided cores as removed can be reused without any problems.

In other aspect, a current transformer according to the present invention comprises a pair of divided cores having a shape of two halves into which a continuous substantially ring-shaped body is divided, a coil wound around one or both of the divided cores, and a hinge member that supports the pair of divided cores so as to be openable and closable, the current transformer being detachably put around an electric wire or cable so that the electric wire or cable passes through a bore portion, which is formed at a center of the pair of divided cores kept in a closed state into a substantially ring-shape, the current transformer further comprises: a fastening member detachably provided in a vicinity of the divided cores so as to be capable of pressing the pair of divided cores to each other from outside in a direction in which the pair of divided cores come close to each other in a state where the pair of divided cores is kept in a closed state in a substantially ring-shape, so as to keep a close contact state between the one ends of the pair of divided cores and between the other ends thereof; and the hinge member is connected to each of the divided cores so that the pair of divided cores causes the one ends and the other ends of the pair of divided cores to face each other to permit a linear relative movement in which the pair of divided cores come close to each other or go away from each other.

According to the present invention, the hinge member by which the pair of divided cores are connected openable and closable, permits, while keeping the connection of the divided cores, to cause the pair of divided cores to move linearly relative to each other to bring the ends of the respective divided cores into contact with each other, and the fastening member that are detachably provided to the pair of divided cores presses from outside the divided cores so that the divided core come close to each other, to keep a close contact state of the ends of the respective divided cores. Relative movement and swing motion of the pair of divided cores connected by means of the hinge member makes it possible to open and close smoothly the divided cores to place them on the outer side of an object such as an electric wire around which the current transformer is to be fitted, and to remove them from the object, thus improving an operation activity. Further, it is possible to continuously ensure the contact of the ends of the cores by preventing the pair of divided cores from separating from each other by the fastening member, to keep surely the magnetic property as the transformer. In addition, if the transformer becomes unnecessary, release of a fixed state by the fastening member makes it possible to remove easily the divided cores from the electric line or the like, and the divided cores become completely free from the fastening member after removal of them, and the divided cores as removed can be reused without any problems.

### [BRIEF DESCRIPTION OF DRAWINGS]

[FIG. 1]

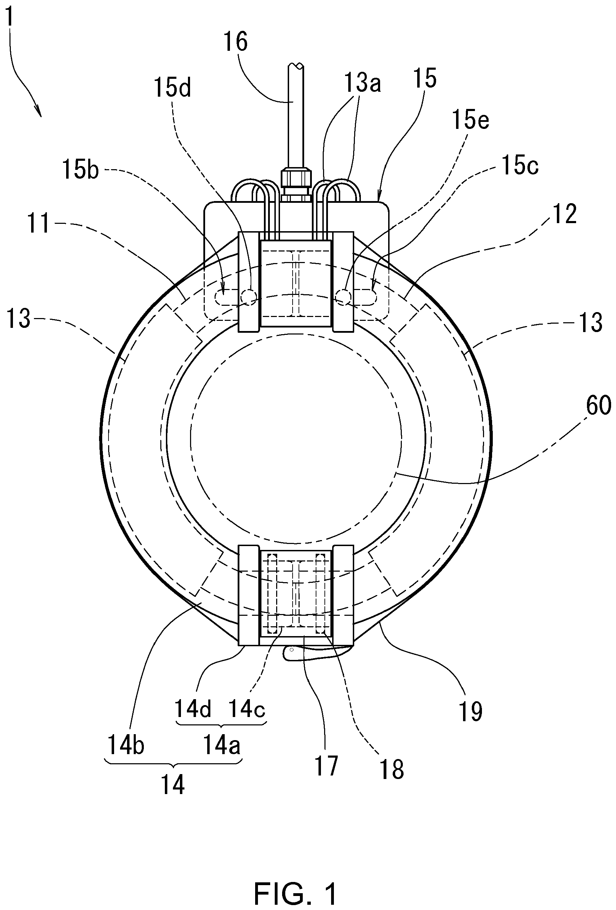

   FIG. 1 is a front view of a current transformer according to the first embodiment of the present invention;
[FIG. 2]

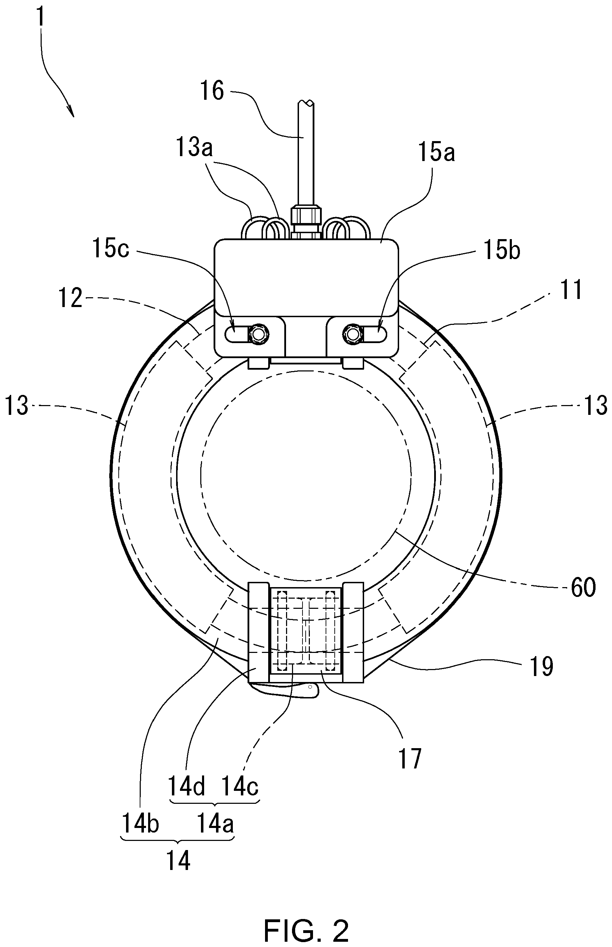

   FIG. 2 is a rear view of the current transformer according to the first embodiment of the present invention;
[FIG. 3]

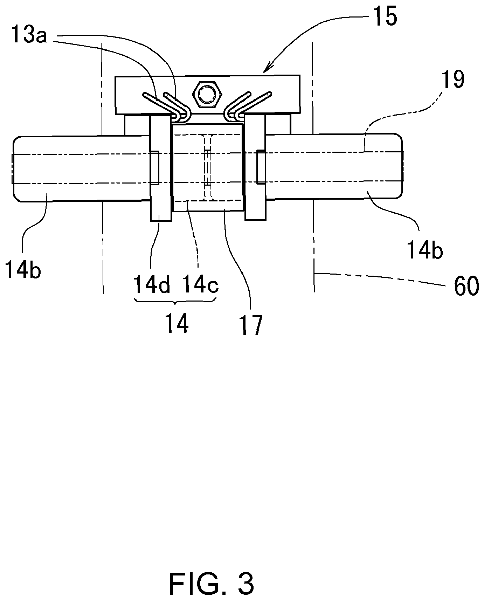

   FIG. 3 is a plan view of the current transformer according to the first embodiment of the present invention;
[FIG. 4]

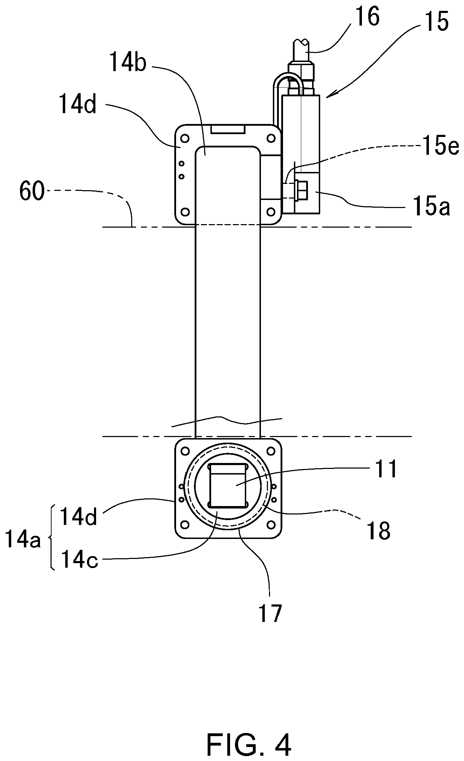

   FIG. 4 is a right-hand side view with broken areas of the current transformer according to the first embodiment of the present invention;
[FIG. 5]

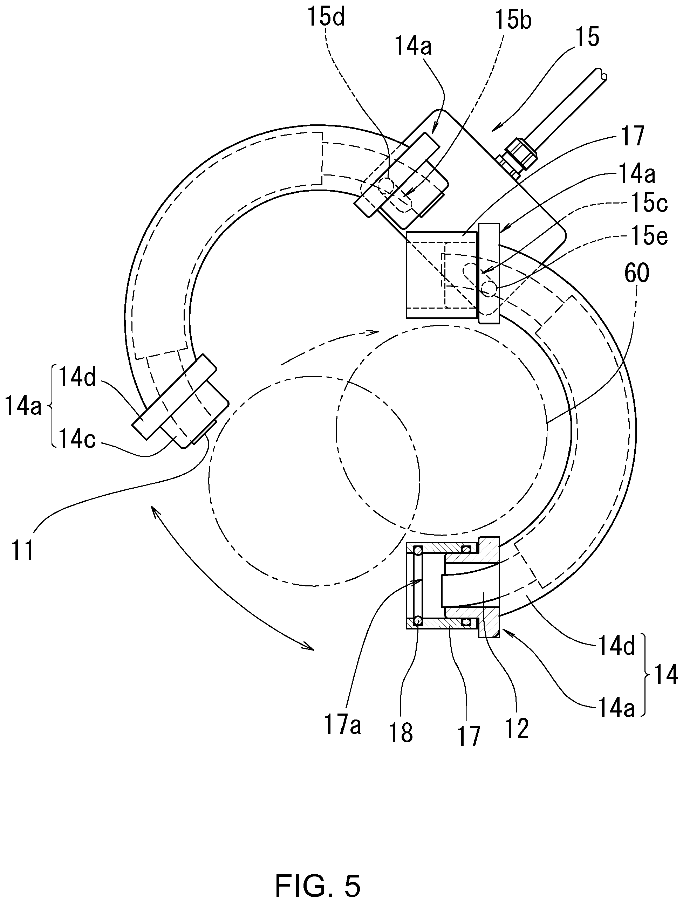

   FIG. 5 is a descriptive view of divided cores in an open state of the current transformer according to the first embodiment of the present invention;
[FIG. 6]

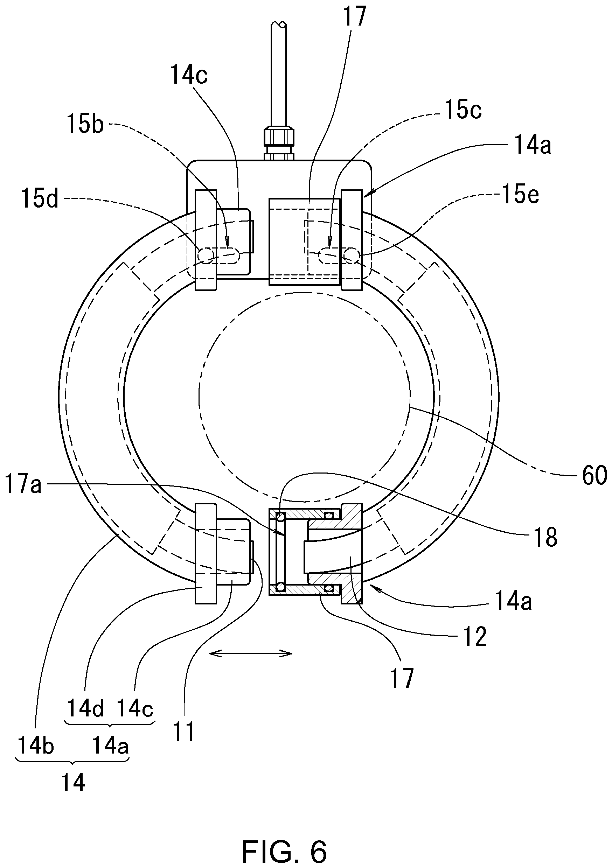

   FIG. 6 is a descriptive view illustrating s state where opposite ends of one of the divided cores are capable of being inserted into connecting members, of the current transformer according to the first embodiment of the present invention;
[FIG. 7]

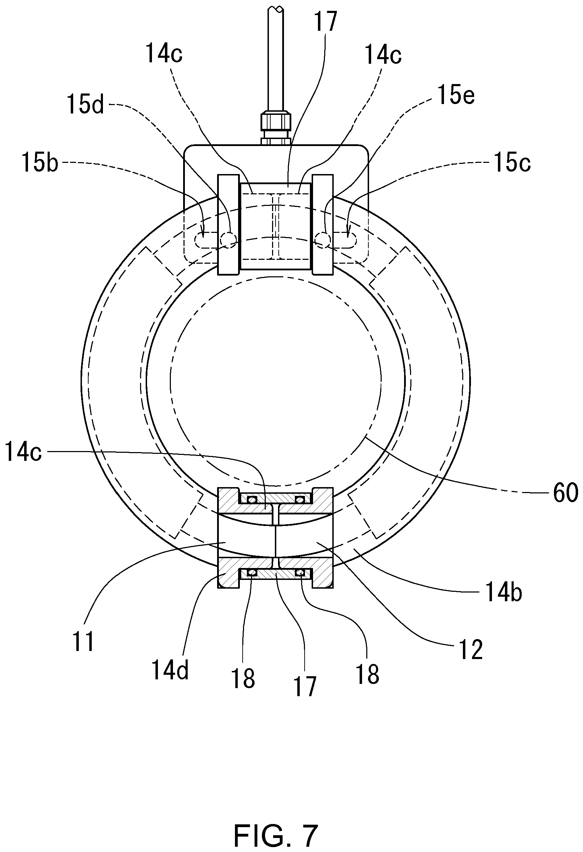

   FIG. 7 is a descriptive view illustrating s state where opposite ends of both of the divided cores are brought into contact with each other, of the current transformer according to the first embodiment of the present invention;
[FIG. 8]

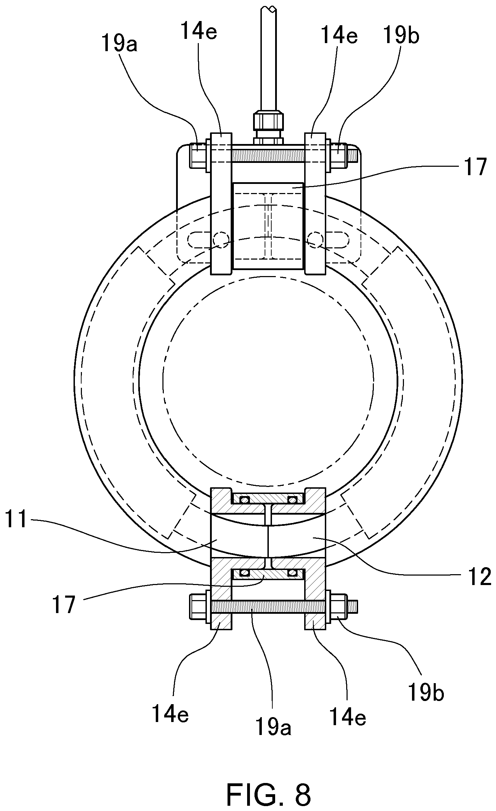

   FIG. 8 is a descriptive view illustrating s state where the divided cores are kept to be fasten by an alternative fastening member, of the current transformer according to the first embodiment of the present invention;
[FIG. 9]

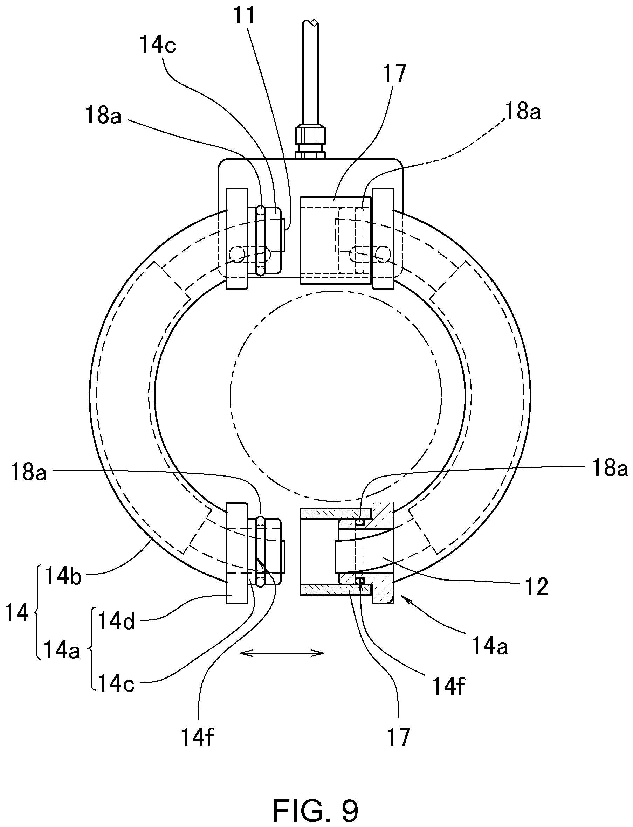

   FIG. 9 is a descriptive view of a structure in which an alternative sealing body is provided, of the current transformer according to the first embodiment of the present invention;
[FIG. 10]

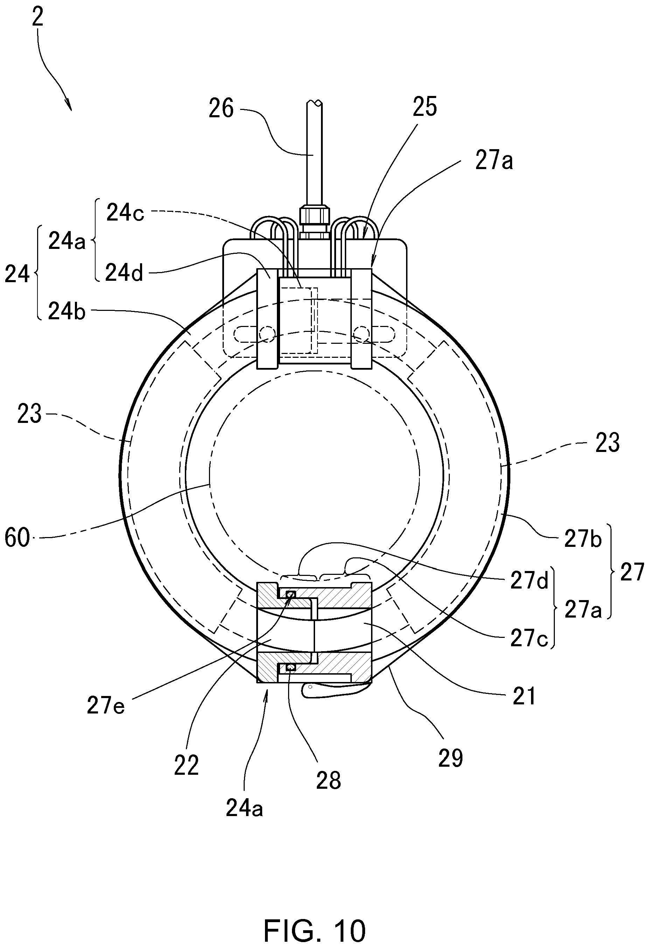

   FIG. 10 is a front view with broken areas of the current transformer according to the second embodiment of the present invention;
[FIG. 11]

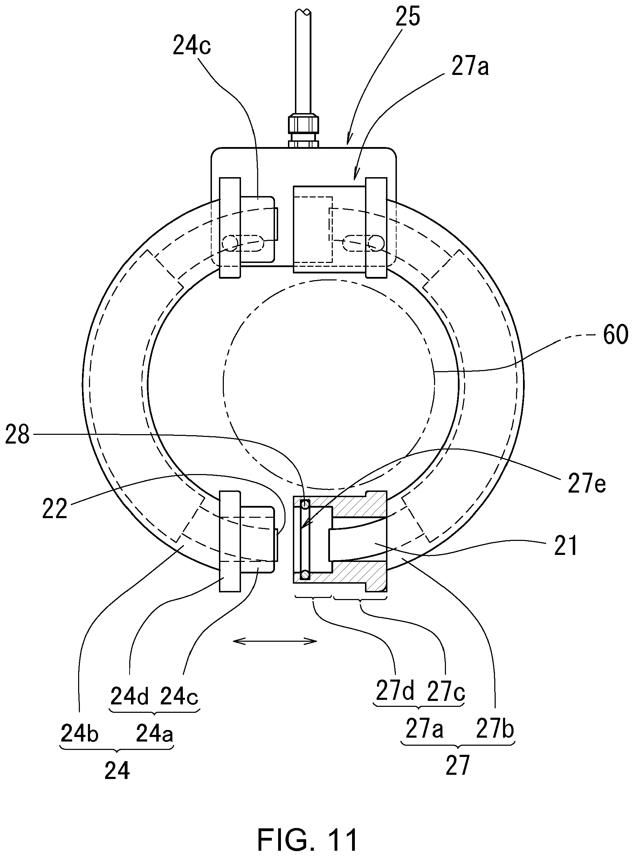

   FIG. 11 is a descriptive view illustrating s state where opposite ends of one of the divided cores are capable of being inserted into connecting members, of the current transformer according to the second embodiment of the present invention;
[FIG. 12]

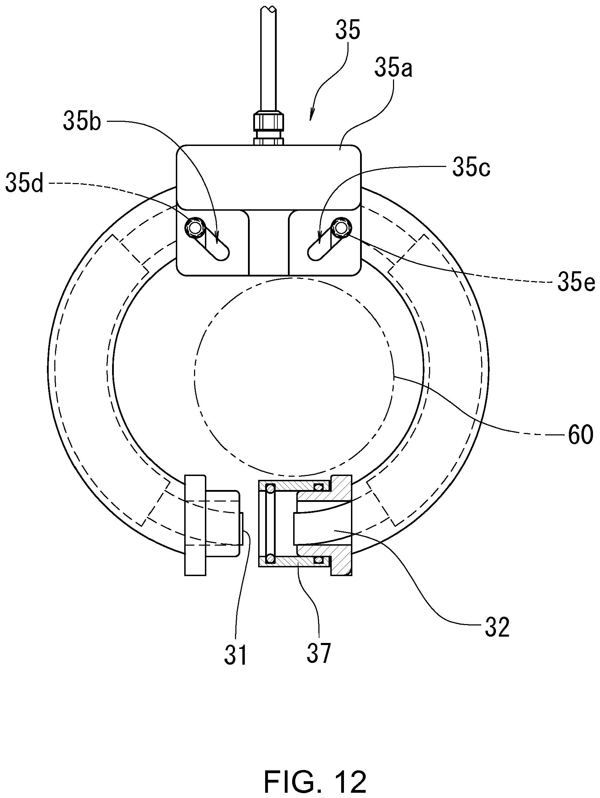

   FIG. 12 is a descriptive view illustrating s state where an end of one of the divided cores is capable of being inserted into a connecting member, of the current transformer according to the third embodiment of the present invention;
[FIG. 13]

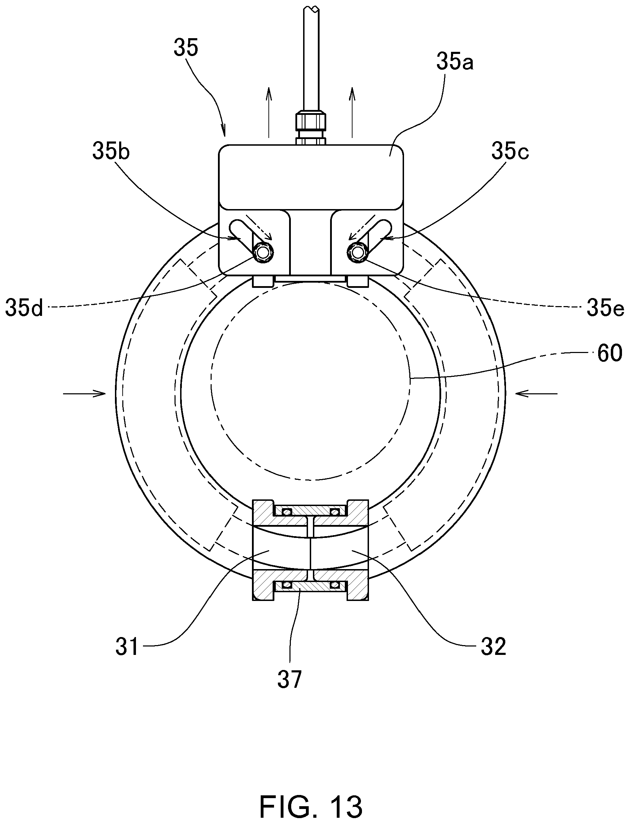

   FIG. 13 is a descriptive view illustrating s state where ends of both of the divided cores are brought into contact with each other, of the current transformer according to the third embodiment of the present invention;
[FIG. 14]

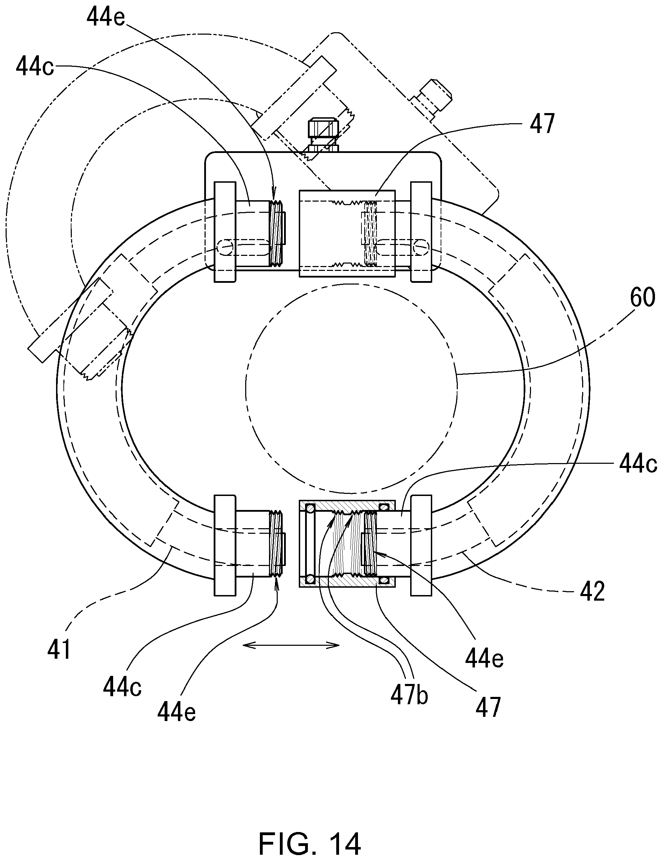

   FIG. 14 is a descriptive view illustrating s state where opposite ends of one of the divided cores are capable of being inserted into connecting members, of the current transformer according to the fourth embodiment of the present invention;
[FIG. 15]

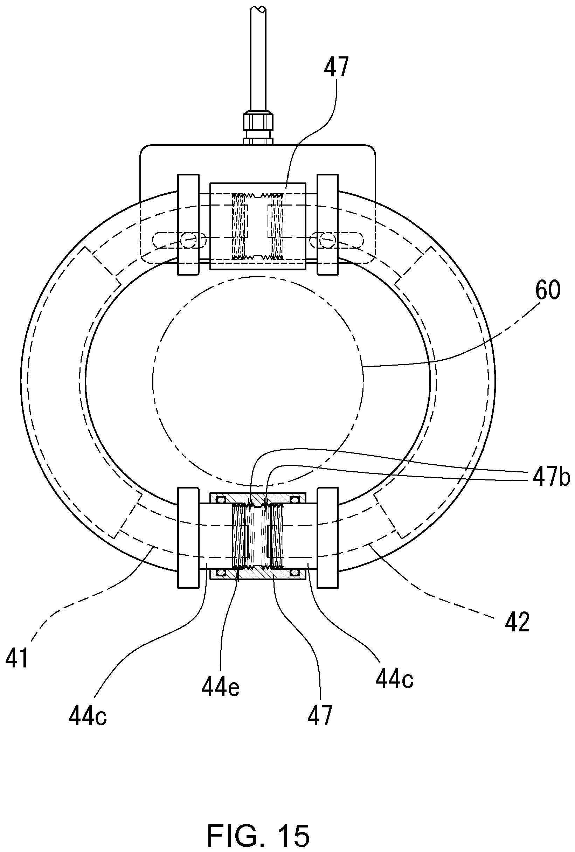

   FIG. 15 is a descriptive view illustrating s state where ends of each of the divided cores are simply inserted into connecting members, of the current transformer according to the fourth embodiment of the present invention;
[FIG. 16]

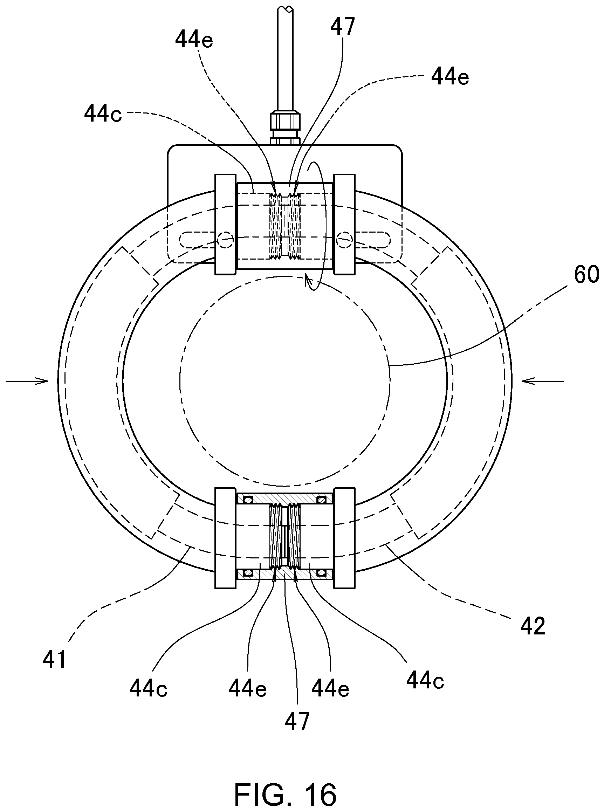

   FIG. 16 is a descriptive view illustrating s state where ends of each of the divided cores are screwed into connecting members, of the current transformer according to the fourth embodiment of the present invention;
[FIG. 17]

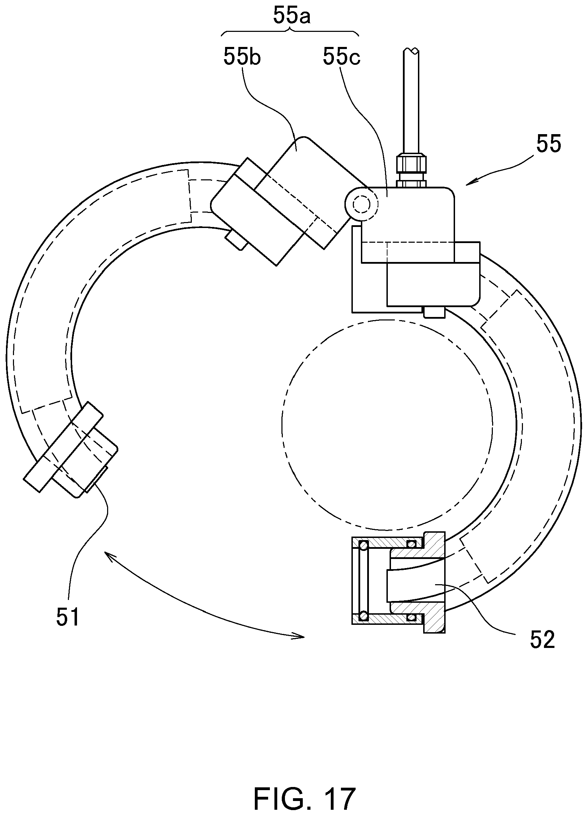

   FIG. 17 is a descriptive view illustrating a state where divided cores are opened, of the current transformer according to the other embodiment of the present invention;
[FIG. 18]

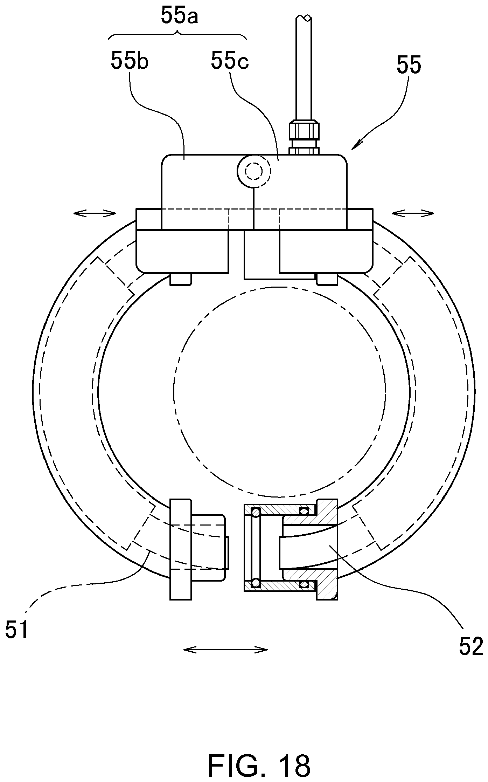

   FIG. 18 is a descriptive view illustrating s state where an end of one of the divided cores is capable of being inserted into a connecting member, of the current transformer according to the other embodiment of the present invention;
[FIG. 19]

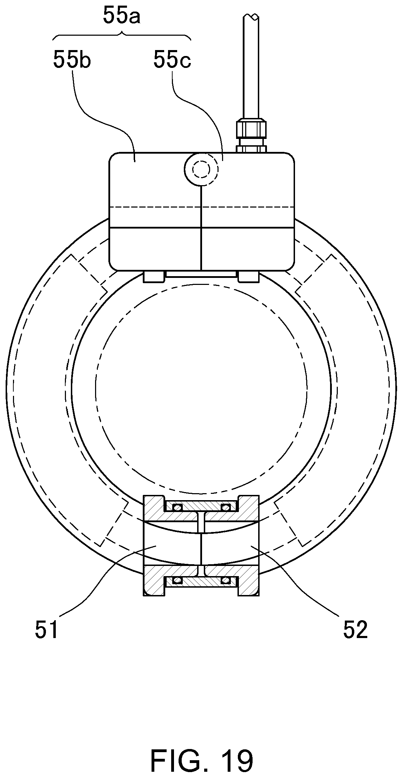

   FIG. 19 is a descriptive view illustrating s state where ends of both of the divided cores are brought into contact with each other, of the current transformer according to the other embodiment of the present invention; and
[FIG. 20]

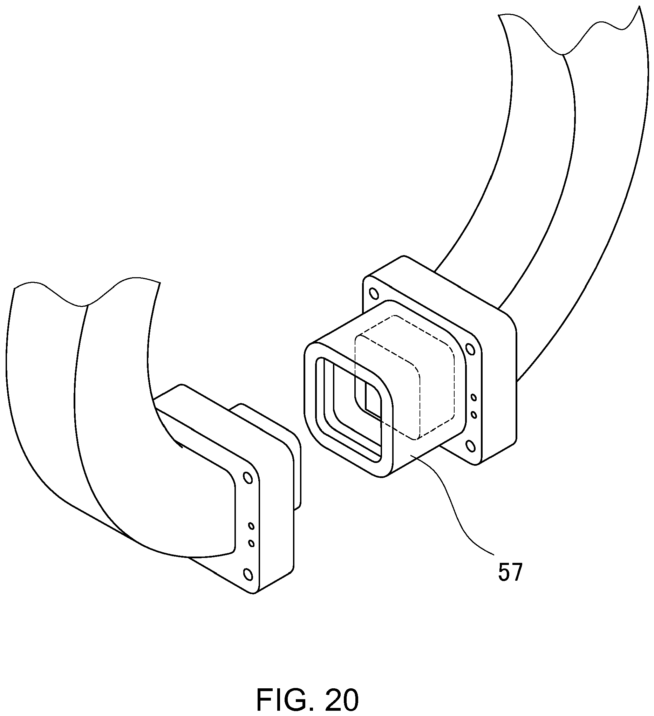

   FIG. 20 is a descriptive view illustrating a shape of the connecting member of the current transformer according to the still other embodiment of the present invention.

### [DESCRIPTION OF EMBODIMENTS]

### [First Embodiment of the Present Invention]

Now, the first embodiment of the present invention will be described below with reference to FIGS. 1 to 7 as indicated above.

A current transformer 1 according to this embodiment of the present invention is provided with a configuration containing a pair of divided cores 11, 12 having a shape of two halves into which a continuous circular ring-shaped body is divided, a coil 13 wound around each of the divided cores 11, 12, an outer cover body 14 covers each of the divided cores 11, 12 with the coils 13, a hinge member 15 that connects the pair of divided cores 11, 12 so as to be openable and closable, electric leading wires 16 electrically connected to the coils and drawn from the hinge member 15, two connecting members 17 each formed as a circular tube, into which corresponding one ends of the divided cores 11, 12 and other ends of them are to be inserted detachably to connect them with each other, sealing bodies 18 formed of elastic material into a ring-shape, which are provided in predetermined two places on the inner surface of a circular tube portion of each of these connecting members 17, and a tightening band 19 as the above-mentioned fastening member provided so as to be detachably stretched around the outside of the divided cores 11, 12 and the connecting members 17, which divided cores are kept in a ring-shape by inserting the opposite ends of each of the divided cores into the respective connecting members 17.

Each of the above-mentioned divided cores 11, 12 is formed of magnetic material such as silicon steel having a high saturation flux density and a high magnetic permeability, and each of them has a shape of two semi circular ring-shaped halves into which a circular ring-shaped body having a substantially square shape in cross section is divided.

The coil 13 is wound around each of the divided cores 11, 12. The pair of divided cores 11, 12 with the wound coils, which are covered with the outer cover body 14, are connected by means of the hinge member 15 into a united body.

In case where these divided cores 11, 12 are put, as the current transformer 1, around an electric wire or cable, so that the electric wire or cable passes through a bore portion, which is formed at a center of the pair of divided cores kept in a closed state into a ring shape.

The above-mentioned outer cover body 14, which is formed of material having a water-proof property and an insulating property, covers an outer peripheral portion, excepting opposite ends of each of the pair of the divided cores 11,12, which face each other, on the one hand, and the wound coil 13, on the other hand, to insulate them from outside.

More specifically, the outer cover body 14 is provided with edge-cover parts 14a for covering portions of each of the divided cores 11, 12, in the vicinity of opposite ends of the divided cores over a predetermined range, and an intermediate cover part 14b provided between these edge-cover parts 14a to cover the intermediate portion of each of the divided cores.

The edge-cover part 14a includes a circular pillar-shaped portion 14c placed on the edge side of each of the divided cores 11, 12 and a flange portion 14d, which is placed adjacently to the intermediate cover part 14b and extends in a flange-shape from the circular pillar-shaped portion 14c. The circular pillar-shaped portion 14c and the flange portion 14d are provided on the opposite ends of the divided cores 11, 12 so that the pillar shape of the circular pillar-shaped portion 14c extend parallel with each other.

The intermediate cover part 14b, which is formed separately from the edge-cover part 14a, covers intermediate portions of the divided cores 11, 12 as well as the coils 13 wound around these intermediate portions of the divided cores. More specifically, the intermediate cover part 14b is formed in a covering state by putting the edge-cover parts 14a on the opposite ends of the divided core 11 or 12, and then covering the exposed intermediate portion and the exposed coil 13 with resin material (plastic or elastomer material) through a molding formation.

The intermediate cover part 14b, as integrally formed through the mold formation in this manner, of the outer cover body 14 has a seamless structure excellent in water-proof property. However, there may be applied an alternative structure in which a plurality of cover parts are joined together to form the intermediate cover part, as long as such a structure can ensure a sufficient water-proof property at the joined range of the plurality of cover parts.

The above-mentioned hinge member 15 has a structure including a hinge member main body 15a provided with two connection holes 15b, 15c, which are formed as an elongated hole having a predetermined length so as to be positioned side by side in a longitudinal direction of the elongated hole; and two supporting shafts 15d, 15e, which are inserted into the connection holes 15b, 15c, respectively, so as to be movable in a longitudinal direction thereof and swingable, to support the above-mentioned divided cores 11, 12.

The supporting shafts 15d, 15e of this hinge member 15 are connected to the flange portions 14d of the edge-cover parts 14a of the cover body 14, which cover the respective divided core 11, 12, on the respective one end of the divided cores, respectively, so that such a connection of the supporting shafts 15d, 15e to the divided cores 11, 12 into a united body, provide a structure in which the respective divided cores 11, 12 are connected to each other by means of the hinge member 15.

The supporting shafts 15d, 15e firmly connected to the divided cores 11, 12 are inserted into the connection holes 15b, 15c of the hinge member main body 15a, respectively, so that the respective divided core 11, 12 is linearly movable and swingable relative to the hinge member main body 15a of the hinge member 15. Such a mechanism permits not only the pair of divided cores 11, 12 to be opened and closed through a relative swing motion of one of the divided cores 11, 12 to the other thereof, but also the pair of divided cores 11, 12 to achieve linear relative movement in which the pair of divided cores 11, 12 come close to each other or go away from each other.

In the structure as described above, each of the two connection holes 15b, 15c of the hinge member main body 15a of this hinge member 15 is formed as the elongated hole so as to be positioned side by side in the longitudinal direction of the elongated hole, and the supporting shafts 15d, 15e are inserted into the connection holes 15b, 15c, respectively, so as to be movable in the longitudinal direction thereof and swingable. The present invention is not limited only to such a structure, and there may be applied another structure in which the two connection holes of the hinge member main body are provided so as not to be positioned side by side in the longitudinal direction of the hole (see for example FIG. 12 and FIG. 13), or an alternative structure in which only one of the two connection holes of the hinge member main body is formed as the elongated hole and the other hole is formed as a normal hole for merely supporting swingably the supporting shaft as inserted into this normal hole. There may be applied another alternative structure in which there is used only one set of the connection hole as the elongated hole of the hinge member and the supporting shaft inserted into this hole, in combination, for only one divided core of the pair of divided cores, so that the hinge member and the one divided core are connected to each other by connecting the supporting shaft of the hinge member to the end of the outer cover body with which this divided core is covered, and the other divided core is connected in a fixed state to the hinge member main body of the hinge member, as long as it permits a relative linear movement of the pair of divided cores. Even in this case, the pair of divided cores can be opened and closed, and the end of the divided core can easily be inserted into or removed from the respective connecting member by causing the one divided core to move linearly and swing relative to the other divided core, which is connected to the hinge member, within a range of movement of the supporting shaft in the connection hole.

There are positioned, on the hinge member main body 15a of the hinge member 15, the lead lines 13a, which are electrically connected to the coils 13 and pass through the inside of the outer cover body 14 and are finally pulled out from the flange portion 14d of the outer cover body 14. These lead lines 13a are electrically connected, in the hinge member main body 15a, to the leading wires 16, which are pulled out separately from the hinge member main body 15a to be connected to an external device. The lead lines 13a are omitted in the other drawings than the major drawings such as a front view for an external appearance of the current transformer.

During a relative movement such as a linear movement or a swing motion of one of the pair of divided cores 11, 12, which are connected to each other by means of the hinge member 15, relative to the other of them, the lead lines 13a positioned between the flange portion 14d of the outer cover body and the hinge member main body 15a are subject almost no influence of tension variation or the line, since there is a small variation in relative position between the flange portion 14d and the hinge member main body 15a. Such a structure where no problem occurs even if the coils 13 are wound around both of the divided cores 11, 12 so that the lead lines 13a are placed in the hinge member 15, makes it possible to ensure a wide width of the wound coil in which the coils 13 are arranged separately in the respective divided cores to effectively utilize a length of magnetic path of the core, with the result that reduction in number of layers of wound line for the coil can in turn reduce the thickness of the coil in the transformer, thus leading to reduction in size of the transformer.

The above-mentioned connecting member 17 is formed as a circular tube shaped member having an inner diameter, which is slightly larger than the circular pillar-shaped portion 14c of the edge-cover part 14a of the outer cover body 14 with which the respective divided core 11, 12 is covered. In addition, the connecting member 17 has a length so that portions extending from the circular pillar-shaped portion 14c of the edge-cover part 14a of the outer cover at the edges of the respective divided cores 11, 12 to the edge of the core, more specifically, a portion positioned from the flange portion 14d of the edge-cover part 14a to the edge are inserted into the inside of the circular tube body from each of the openings of the opposite ends of the circular tube body for forming the connecting member 17, to bring the ends of the divided core 11 into contact with the ends of the divided core 12, respectively. Each of the connecting members 17 is provided with a ring-shaped groove 17a into which the ring-shaped sealing body 18 is fitted, at two positions on the inner surface of the circular tube portion in the vicinity of the opposite ends of the circular tube portion in a direction along which the circular tube shape continuously extends.

In accordance with such a structure in which the opposite ends of the divided core 11 and the opposite ends of the divided core 12 can detachably be inserted into the openings of the circular tube portions of the two connecting members 17, the pair of divided cores 11, 12 can be kept in a closed state in a ring shape by inserting the edges of the divided cores 11, 12 into these connecting members 17.

The flange portion 14d of the edge-cover part 14a of the outer cover body has a larger size with which the flange portion 14d cannot be inserted into the connecting member 17, so as to prevent the edge of the divided core from being inserted into the connecting member 17 beyond the circular pillar-shaped portion 14c of the edge-cover part 14a, thus surely inhibiting insertion of the edge of the divided core into the connecting member 17 in an excessive amount.

The above-mentioned sealing body 18, which is a ring-shaped body formed of elastic material, such as an O-ring, is placed along the inner peripheral surface of the connecting member 17 by inserting the sealing bodies into the respective grooves 17a formed at two positions on the inner surface of the circular tube portion of the respective connecting member 17 in the vicinity of the opposite ends of the circular tube portion in a direction along which the circular tube shape continuously extends. The sealing body 18 is placed between the inner periphery of the connecting member 17 and the outer periphery of the circular pillar-shaped portion 14c of the outer cover body in a state where the edge of the respective divided core 11, 12 together with the outer cover body 14 are inserted into the above-mentioned connecting member 17, so that the sealing body 18 comes, with elastic deformation, into close contact with the connecting member 17 and the circular pillar-shaped portion 14c of the outer cover body, without creating a gap between them, thus preventing water from penetrating in the edge sides of the divided cores 11, 12.

A simple water-proof structure utilizing the sealing bodies 18 and the connecting members 17 permits to form the divided cores 11, 12 of uniform material over their entirety. For example, use of material such as silicon steel having a high saturation flux density and a high magnetic permeability makes it possible to reduce a size and weight of the whole of the transformer. Alternatively, material (for example silicon steel) which is cheap, but apt to rust can be applied to formation of the divided cores, and in this case, manufacturing costs can be reduced.

The above-mentioned tightening band 19 is a band, which is formed by connecting the opposite edges of a band formed of metallic material, or the like which is capable of being elastically deformed, into a ring shape, so that a length of the ring-shaped portion can be adjusted, thus permitting to fasten an object placed in the ring shaped portion. The tightening band 19 is placed so as to encompass the outside of the combined unit of the divided cores 11, 12 and the connecting members 17, in a state where the ends of the divided cores 11, 12 are inserted together with the outer cover body 14 into the connecting members 17 to keep a closed state of the pair of divided cores in a substantially ring-shape, and the above-mentioned combined unit is fasten from outside so as to press the pair of divided cores 11, 12 together from outside in directions in which the pair of divided cores 11, 12 come close to each other. The tightening band 19 presses the pair of divided cores 11, 12 together from outside to serve as the fastening member to keep a close contact state between the one ends of the pair of divided cores and between the other ends thereof.

Now, a setting process of the current transformer with the above-described structure will be described in an example where it is set around an overhead electric line for electric transmission. There is an assumption that the opposite ends of the one divided core 11 are previously removed from the connecting members 17, on the one hand, and the opposite ends of the other divided core 12 are inserted into the connecting members 17, on the other hand, and that the one divided core is caused, where appropriate, to move linearly and/or swing relative to the other divided core, to keep a state in which the divided cores 11, 12 are opened.

First, the pair of divided cores 11, 12 and the hinge member 15 are placed in the vicinity of an electric line 60 so that the electric line 60 is placed between the divided cores 11, 12, which are kept in an open state (see FIG. 5). From this state, the one divided core is swung relative to the other divided core to cause the ends of the divided core to face squarely the openings of the respective connecting members 17 (see FIG. 6). At this time, the divided cores 11, 12 are permitted to swing by causing the supporting shafts 15d, 15e to rotate within the connection holes 15b, 15c of the hinge member 15, respectively, thus easily providing a state where the opposite edges of the one divided core face the opposite edge of the other divided core, respectively.

In addition, in the hinge member 15, the divided cores 11, 12 are also permitted to linearly move by causing the supporting shaft 15d, 15e to move within the connection holes 15b, 15c of the hinge member 15, respectively. Accordingly, the one divided core 11 is linearly moved relative to the other divided core, while holding the divided cores 11, 12, and the circular pillar-shaped portions 14c at the opposite ends of the one divided core 11 are inserted into the connecting members 17, respectively. The circular pillar-shaped portions 14c of the outer cover body 14 at the opposite end of the respective divided cores are provided so that the pillar shape of the circular pillar-shaped portion 14c extend parallel with each other, thus making it possible to achieve a linear movement in one direction, to smoothly insert the circular pillar-shaped portions 14c into the respective connecting members 17 having the similar parallel configuration in an easy manner.

With such an insertion, the sealing body 18 comes into close contact with the inner peripheral surface of the connecting member 17 and the outer peripheral surface of the circular pillar-shaped portion 14c of the outer cover body on the outer side of the edges of the divided core, respectively, without creating a gap between them, thus preventing water from penetrating in the edge sides of the divided cores.

When the circular pillar-shaped portions 14c on the opposite ends of the one divided core 11 are completely inserted into the connecting members 17, there can be provided a state where the ends of the divided cores 11, 12 come into contact with each other, respectively (see FIG. 7). In this state, the flange portion 14d of the outer cover body comes into contact with the edge of the opening of the connecting member 17, so as to surely inhibit insertion of the edge of the divided core in an excessive amount even if any force is applied to the divided core in an insertion direction.

When there is provided a state where the pair of divided cores 11, 12 are closed and the electric line 60 passes through a bore portion at a center of the cores, the tightening band 19 is placed so as to encompass the outside of the combined unit in a ring shape of the pair of divided cores 11, 12 and the two connecting members 17, and then fastened to press the divided cores together and keep them in this state, so as to prevent the divided cores 11, 12 from moving in a direction in which the edges of the divided cores are removed from the connecting members 17 to release a state in which the opposite ends of the one divided core come close contact with the opposite ends of the other divided core. When the placing and setting step of the tightening band 19 is completed so as not to be easily removed from the outside of combination of the divided cores 11, 12 and the connecting members 17 (see FIG. 1 and FIG. 2), the setting process of the transformer is completed.

In the current transformer according to this embodiment of the present invention, the pair of divided cores 11, 12, which are openably and closably connected to each other by means of the hinge member 15, are closed in a ring-shape by inserting the ends of the respective divided cores into the connecting members 17 having the circular tube shape, and the pillar-shaped portions 14c of the outer cover body 14 at the ends of the divided cores 11, 12 are detachably inserted into the inside of the connecting members 17, so that the sealing body 18 having the ring-shape provides a sealing performance between the inner surface of the circular tube portions of the connecting members 17 and the outer surface of the pillar-shaped portions 14c of the outer cover body 14, which surfaces face each other. It is therefore possible to ensure easily a water-proof state by bringing the sealing body 18 into contact with the connection members 17 and the pillar-shaped portions 14c of the outer cover body, with elastic deformation of the sealing body 18, and simplify the respective structures for providing a water-proof performance, thus making it possible to reduce a size and weight of the transformer and reduce a manufacturing cost.

Further, the end of the core 17 and the outer cover body 14 are detachably inserted into the connecting member 17, and movement of the divided cores 11, 12 only in a linear direction is permitted in a insertion state. Therefore, a water-tight state by the sealing body 18 is still kept, unless the divided core 11, 12 comes off from a position of the sealing body 18 in the connecting member 17, even if the connection of the divided core relative to the connecting member 17 becomes loose, thus making it possible to maintain a water-proof performance, prevent deterioration of the core due to water, and secure insulation of an electric circuit. Further, permitting the pair of divided cores 11, 12 connected by the hinge member 15 to move linearly and swing makes it possible to open and close the divided cores 11, 12 smoothly so as to place rapidly the current transformer on the outer side of an object such as an electric wire around which the current transformer is to be fitted, and to remove it from the object, thus improving an operation activity.

The current transformer according to the above-described embodiment of the present invention has a structure in which the tightening band 19 as the fastening member is the band, which is formed by connecting the opposite edges of a band formed of metallic material, or the like which is capable of being elastically deformed, into a ring shape, so that a length of the ring-shaped portion can be adjusted, and the pair of divided cores 11, 12, which are closed in a ring shape, together with the connecting members 11 are fasten from outside so as to press the pair of divided cores 11, 12 together from outside in a direction in which the pair of divided cores 11, 12 come close to each other. Alternatively, another fastening member such as a set of bolt and nut may be applied, as long as it can keep the close contact state between the opposite ends of the pair of divided cores 11, 12. For example, there may be applied a structure in which the flange portion 14e having an extended portion formed integrally with it, are used at the ends of the divided cores 11, 12, and the pair of divided cores 11, 12 are pressed together in directions in which the pair of divided cores 11, 12 come close to each other by causing a bolt 19a to pass through the two respective extended portions of the flange portions 14e, which face each other, and attaching a nut 19b to the bolt 19a and conducting a fastening operation, as shown in FIG. 8. In this case, if the transformer becomes unnecessary even after completion of the setting process of the divided cores, it is possible to remove easily the divided cores from the electric wire or the like, and the divided cores as removed can be reused without any problems.

Further, the current transformer according to the above-described embodiment of the present invention has a structure in which the tightening body 19 in a shape of band is used, as the fastening member for keeping a close contact state between the opposite ends of the divided cores, in order to fasten outside the pair of divided cores 11, 12 and the connecting members 17. Alternatively, there may be applied, in place of such a fastening member, a structure in which the hinge member, which permits a linear relative movement in which the divided cores come close to each other or go away from each other, has a mechanism that can reversibly provide a state where a relative movement of the divided cores cannot be permitted, when the edges of the divided cores move linearly to be inserted into the connecting members and the respective opposite ends of the divided cores come finally into contact with each other, in order to keep a close contact state between the opposite ends of the pair of divided cores.

In particular, in the structure of the hinge member according to the above-described embodiment of the present invention, there is provided a predetermined mechanism that regulates movement of the supporting shafts 15d, 15e of the hinge member 15, which are integrally connected to the divided cores 11, 12, within the connection holes 15b, 15c in the longitudinal direction of the hole, in a state where the opposite ends of the divided cores 11, 12 come into contact with each other. In this case, there may be used a mechanism that is provided on the side of the hinge member main body 15a to regulate movement of the supporting shafts 15d, 15e, by causing a predetermined movable portion provided on the side of the supporting shafts 15d, 15e to act (i.e., cause friction, engagement, etc.) on the side of the hinge member main body 15a to inhibit the supporting shafts 15b, 15c from moving, or by closing a part of the connection holes 15b, 15c, as long as the mechanism can hold the supporting shafts 15d, 15e in the positions for them within the connection holes 15b, 15d, when the opposite ends of the divided cores 11, 12 come into contact with each other.

Use of such a mechanism, which has a sufficient strength for regulating the movement of the supporting shafts 15d, 15e relative to the hinge member main body 15a, so as to inhibit the relative movement between the divided cores, can make the fastening member for holding the divided cores unnecessary, thus making it possible to reduce time and labor for putting the fastening member and control costs for a putting operation of the current transformer. In the above-described structure of the hinge member, It is further preferable not to regulate the movement of the supporting shafts 15d, 15e relative to the hinge member main body 15a, but also to regulate rotation of the supporting shafts 15d, 15e, thus making it possible to inhibit backlash and misalignment from occurring in the closed state of the divided cores due to looseness and dimension error in the respective portions of the hinge member.

Further, the current transformer according to the above-described embodiment of the present invention has a structure in which the sealing bodies 18 formed of the elastic material into the ring shape are placed in the respective two grooves 17a formed on the inner surface of the circular tube portion in the vicinity of the opposite ends of the circular tube portion of the respective connecting member 17 in a direction along which the circular tube shape continuously extends, into which circular tube portion the respective opposite ends of the pair of divided cores 11, 12 are inserted. The present invention is not limited only to such a structure. There may be applied, in place of providing the sealing bodies on the side of the connecting member in this manner, a structure in which the sealing body 18a is provided on the side of the circular pillar-shaped portion 14c of the outer cover body at the end of the respective divided core 11, 12, as shown in FIG. 9. In this case, a groove 14f is formed on the outer surface of the circular pillar-shaped portion 14c of the outer cover body so as to extend in the circumferential direction thereof at the end of the respective divided cores 11, 12, and the sealing body 18a formed of the elastic material into the ring shape is placed in this groove 14f. Because of this, the sealing body 18 is placed between the inner periphery of the connecting member 17 and the outer periphery of the circular pillar-shaped portion 14c of the outer cover body in a state where the edge of the respective divided core 11, 12 together with the outer cover body 14 are inserted into the connecting member 17 in the same manner as the above-described embodiment of the present invention, so that the sealing body 18 comes, with elastic deformation, into close contact with the connecting member 17 and the circular pillar-shaped portion 14c of the outer cover body, without creating a gap between them, thus surely preventing water from penetrating in the edge sides of the divided cores 11, 12.

### [Second Embodiment of the Present Invention]

Now, the second embodiment of the present invention will be described below with reference to FIG. 10 and FIG. 11 as indicated before.

A current transformer 2 according to this embodiment of the present invention is provided with the pair of divided cores 21, 22, the coil 23, the outer cover bodies 24, 27, the hinge member 25, the electric leading wires 26 and the tightening band 29, in the same manner as the first embodiment as described above of the present invention, and has a different structure in which the two connecting member 27a each formed as a circular tube body are provided as a part of the outer cover body 27 that covers the one divided core 21 at the opposite ends of the one divided core 21, and the one end of the other end of the other divided core 22 are detachably inserted into the circular tube bodies of the connecting members, on the one hand, and a sealing body 28 formed of elastic material into a ring-shape is provided only in a single place on the inner surface of the circular tube portion of each of the connecting members 27a.

The above-mentioned divided cores 21, 22, coil 23, outer cover body 24, hinge member 25, electric leading wires 26 and tightening band 29 have the same structures as those in the first embodiment as described above of the present invention, and description of them will be omitted. The structure of the outer cover body 27 is also the same as that in the first embodiment as described above of the present invention, except for the end at which the connecting member 27a is provided on the side of the one divided core 21, and detailed description of this structure will be omitted.

The above-mentioned outer cover body 27 covers an outer peripheral portion, excepting opposite ends of the one divided core 21, which face the other divided core 22, on the one hand, and the coil 23, on the other hand, to insulate them from outside. However, there is a different structure in which, in place of the edge-cover part 14a serving as a part of the outer cover body 14 in the first embodiment as described above of the present invention, the connecting member 27a corresponding to a combination of the edge-cover part 14a and the connecting member of the circular tube shaped member is provided.

More specifically, the outer cover body 27 is provided with the connecting members 27a that cover the opposite ends portions in the respective predetermined ranges of the divided core 21, and with an intermediate cover part 27 that covers the intermediate portion between the connecting members 27a.

The connecting member 27a has a base portion 27c, which cover the edge of the divided core 21 in a predetermined range in the vicinity of the edge of the divided core, and placed adjacently to the intermediate cover part 27b, and a circular tube shaped portion 27d formed as a circular tube shaped part projecting from the above-mentioned base portion 27c toward the end face of the divided core 21, and the connecting member is fixedly provided on the opposite ends of the divided core 21 so that the tube shape of the circular tube shaped portion 27d extend parallel with each other.

The circular tube shaped portion 27d of the connecting member 27a is designed to have a length so that a portion extending from the circular pillar-shaped portion 24c to the end surface of the core of the edge-cover part 24a of the outer cover body at the end of the divided core 21, i.e., a portion on the edge side from the flange portion 24d of the edge-cover part 24a is inserted into the inside of the circular tube shaped portion 27d from the opening of it, and the opposite ends of the each of the divided cores 21, 22 are come in contact with each other.

In accordance with such a structure in which the connection members 27a at the opposite ends of the divided core 21 permit the opposite ends of the other divided core 22 to be detachably inserted into the openings of the circular tube shaped portions 27d, respectively, and the pair of divided cores 21, 22 can be kept in a closed state in a ring shape by inserting the edges of the divided core 22 into these connecting members together with the outer cover body 24..

The intermediate cover part 27b, which is formed separately from the connecting member 27a, covers an intermediate portion of the divided core 21, as well as the coil 23 wound around this intermediate portion of the divided core. More specifically, the intermediate cover part 27b is formed in a covering sate, in the same manner as the first embodiment as described above of the present invention, by putting the connecting members 27a on the opposite ends of the divided core 21, and then covering the exposed intermediate portion of the core and the exposed coil 23 with resin material through a molding formation.

The above-mentioned sealing body 28, which is a ring-shaped body formed of elastic material, such as an O-ring, is placed along the inner peripheral surface of the connecting member 27a by inserting the sealing body into the groove 27e formed at a position on the inner surface of the circular tube portion of the connecting member 27a in the vicinity of the end of the circular tube portion in a direction along which the circular tube shape continuously extends. The sealing body 28 is placed between the inner periphery of the circular tube shaped portion 27d of the connecting member 27a and the outer periphery of the circular pillar-shaped portion 24c of the outer cover body in a state where the edge of the divided core 22 together with the outer cover body 24 are inserted into the above-mentioned connecting member 27a, so that the sealing body 28 comes, with elastic deformation, into close contact with the circular tube shaped portion 27d of the connecting member and the circular pillar-shaped portion 24c of the outer cover body, without creating a gap between them, thus preventing water from penetrating in the edge sides of the divided cores 21, 22.

Now, a setting process of the current transformer with the above-described structure will be described in an example where it is set around an overhead electric line for electric transmission. There is an assumption that the opposite ends of the one other divided core 21 are previously removed from the connecting members 27a at the opposite ends of the one divided core 21, and that the one divided core is caused, where appropriate, to move linearly and/or swing relative to the other divided core, to keep a state in which the divided cores 21, 22 are opened.

First, the pair of divided cores 21, 22 and the hinge member 25 are placed near an electric wire 60 so that the electric wire 60 is positioned between the divided cores, which are kept in an opened state. Then, the one divided core is swung relative to the other divided core so that the edges of the divided core 22 face squarely the opening of the respective connecting members 27a of the divided core 21 (see FIG. 11).

Then, the one divided core is linearly moved relative to the other divided core, while holding the respective divided cores 21, 22, so that the portions projecting forward from the respective circular pillar-shaped portions 24c at the opposite ends of the divided core 22 are inserted into the circular tube shaped portions 27d of the connecting members at the opposite ends of the divided core 21, respectively. Each of the circular pillar-shaped portions 24c of the outer cover bodies at the opposite ends of the divided core is shaped so that the circular pillar shape extend parallel with each other, thus making it possible to achieve a linear movement in one direction, to smoothly insert the circular pillar-shaped portions 24c into the respective circular tube shaped portions 27d of the connecting members having the similar parallel configuration in an easy manner.

With such an insertion, the sealing body 28 comes into close contact with the inner peripheral surface of the circular tube shaped portion 27d of the connecting member of the divided core 21 and the outer peripheral surface of the circular pillar-shaped portion 24c of the outer cover body on the outer side of the edges of the divided core 22, respectively, without creating a gap between them, thus preventing water from penetrating in the edge sides of the divided cores.

When the circular pillar-shaped portions 24c at the opposite ends of the divided core 22 are completely inserted into the circular tube shaped portions 27d of the connecting members on the side of the divided core 21, there can be provided a state where the ends of the divided cores 21, 22 come into contact with each other, respectively.

When there is provided a state where the pair of divided cores 21, 22 are closed and the electric line 60 passes through a bore portion at a center of the cores, the tightening band 29 is placed so as to encompass the outside of the combined unit in a ring shape of the pair of divided cores 21, 22, and then fastened to press the divided cores together and keep them in this state, so as to prevent the divided cores 21, 22 from moving in a direction in which the divided core 22 is removed from the connecting members 27 on the side of the divided core 21 to release a state in which the opposite ends of the one divided core come close contact with the opposite ends of the other divided core. When the placing and setting step of the tightening band 29 is completed so as not to be easily removed from the outside of combination of the divided cores 21, 22 (see FIG. 10), the setting process of the transformer is completed.

In the current transformer according to this embodiment of the present invention, the pair of divided cores 21, 22, which are openably and closably connected to each other by means of the hinge member 15, are closed in a ring-shape by inserting the ends of the other divided core into the circular tube shaped portion 27d of the connecting members 17 at the opposite ends of the divided core 21, and the pillar-shaped portions 24c of the outer cover body at the ends of the divided core 22 are detachably inserted into the inside of the circular tube shaped portion 27d of the connecting members at the ends of the divided core, so that the sealing body 28 having the ring-shape provides a sealing performance between the inner surface of the circular tube shaped portion 27d of the connecting members and the outer surface of the pillar-shaped portions 24c of the outer cover body, which surfaces face each other. It is therefore possible to ensure easily a water-proof state by bringing the sealing body 28 into contact with the circular tube shaped portion 27d of the connecting members and the pillar-shaped portions 24c of the outer cover body, with elastic deformation of the sealing body 28, and simplify the respective structures for providing a water-proof performance, thus making it possible to reduce a size and weight of the transformer and reduce a manufacturing cost.

The current transformer according to the above-described embodiment of the present invention has a structure in which the two connecting members 27a are provided as a part of the outer cover body 27 that covers the one divided core 21 at the opposite ends of the one divided core 21, and the one end and the other end of the other divided core 22 can detachably inserted into the inside of the respective connecting members 27, so that the opposite ends of the divided core 22 are inserted into the respective connecting members 27a, there can be provided a state where the pair of divided cores 21, 22 are closed in a ring shape. The present invention is not limited only to such an embodiment. There may be applied a structure in which the connecting members are provided in each of the pair of divided cores, and more specifically, the one end of the one divided core and the other end of the other divided core are provide with the connecting member, respectively, and the one end of the other divided core can detachably inserted into the connecting member of the one divided core and the other end of the one divided core can detachably inserted into the connecting member of the other divided core so that into the connecting members of the respective divided core, the corresponding ends of the other divided core is inserted to keep the pair of divided cores in a ring-shaped closed state. It is therefore possible to bring the corresponding opposite ends of the divided cores into contact with each other in a closed state of the pair of divided cores, and bring the sealing body provided between the connecting member and the outer cover body into contact with the connecting member and the outer cover body, with elastic deformation of the sealing body, so as to simply ensure a water-proof state.

The current transformer according to the above-described first and second embodiments of the present invention has a structure of preventing water from penetrating into the edges of the divided cores 11, 12, 21, 22 within the connecting members 17, 27a by inserting the circular pillar-shaped portions 14c, 24c of the outer cover body at the ends of the divided cores 11, 12, 22 into the inside of the connecting members 17, 27a having the tube shape and by bringing the sealing body 18, 28 provided on the inner surface portion of the connecting members 17, 27a or the outer surface portion of the circular pillar-shaped portions 14c, 24c of the outer cover body into close contact with the connecting members 17, 27a and the circular pillar-shaped portions 14c, 24c of the outer cover body, respectively. However, the present invention is not limited only to such a structure. There may be applied a structure in which the ends of the outer cover body for covering the ends (i.e., the predetermined areas in the vicinity of the opposite ends) of the divided cores are designed to have a tube shape into which the ends of the connecting members can be inserted and which tube shape have the similar opening shape to the outer shape in cross section of the connecting members, so that in a state where the ends of the divided core are inserted into the connecting members, the ends of the connecting members are inserted into the ends having the tube shape of the outer cover body, and the sealing body is placed between the outer peripheral portion of the connecting member and the inner peripheral portion of the end having the tube shape of the outer cover body, which is positioned at the outer side, thus maintaining the water-tight sate between the connecting member and the outer cover body by means of this sealing body.

In this case, the sealing body is positioned between the outer peripheral portion of the connecting member and the inner peripheral portion of the end having the tube shape of the outer cover body by inserting the ring-shaped sealing body into the groove formed on the outer peripheral portion of the connecting member or inserting the ring-shaped sealing body into the grove formed on the inner peripheral portion of the end having the tube shape of the outer cover body to put the sealing body on the connecting member or the outer cover body, with the result that, in the state where the end of the divided core is inserted into the connecting member, the sealing body is placed between the outer peripheral portion of the connecting member and the inner peripheral portion of the end having the tube shape of the outer cover body to bring this sealing body into close contact with the connecting member and the tube portion of the outer cover body, thus making it possible to prevent surely water from penetrating into the connecting member.

In case where the end of the outer cover body on the other end side of the divided core has the similar tube shape (including the connecting member, which is designed to become a part of the outer cover body), the end having the tube shape of the outer cover body in such a structural example is designed so that the tube shape of the other end extend parallel with each other, and in another case where the other end has a pillar shape in an opposite manner, it is designed so that the pillar shape of the other end extend parallel with the tube shape of the above-mentioned end.

The current transformer according to the above-described first and second embodiments of the present invention has a structure in which the pair of divided cores are prepared respectively so as to have a shape of two halves into which the circular ring-shaped body is divided equally. The present invention is not limited only to such a structure. There may be applied another structure in which, as long as it is a shape of two halves into which a continuous substantially ring-shape is divided, there is used a shape of two halves into which a ring-shaped body having a shape of an ellipse or oval is divided (see FIG. 14 to FIG. 16), or there is used a combination of two divided cores joined together, having quite different shapes from each other by using for example one divided core having a semi-circular shape or a substantially U-shape and another divided core having a substantially I-shape, so as to provide a continuous substantially ring shape in a joined state.

### [Third Embodiment of the Present Invention]

The current transformer according to the first and second embodiments as described above of the present invention has a structure in which the two connection holes in the hinge member are formed so as to be positioned side by side in the longitudinal direction of the hole. There may be applied a structure, as the third embodiment of the present invention, in which the connection holes 35b, 35c of the hinge member 35 are placed in a shape of "\ /" (the distance between two lines becomes wider upward) as shown in FIG. 12 and FIG. 13. In this case, utilizing a phenomenon that, when the divided cores 31, 32 linearly move for inserting the end of the divided core 31 into the connecting member 37, the hinge member main body 35a also simultaneously moves relative to the connecting member 37 in the different direction from that of the above-mentioned linear movement, when a force for pressing the hinge member 35 upward is applied to cause a relative movement in a vertical direction between the hinge member 35 and the connecting member 37 in a state where the divided cores 31, 32 are placed so that the ends of them face squarely between which the connecting member 37 is positioned (see FIG. 12), the divided cores 31, 32 linear move so that the respective ends of them facing squarely come close to each other (see FIG. 13), thus easily causing a motion for inserting the ends of the divided cores 3, 32 into the connecting member 37, without conducting any operation for the divided cores 31, 32.

In a state where the current transformer is put around the electric wire 60, the electric wire 60 bears the weight of the current transformer, and an relatively upward force is applied to the current transformer from the electric wire 60. Accordingly, when the hinge member 35 is positioned on the upper side of the current transformer to be positioned on the upper side of the electric wire 60, the upward force is applied to the hinge member 35 from the electric wire 60, so as to restrict the position of the hinge member relative to the connecting member 37 in a downward direction, thus preventing an occurrence of a problem that the relative movement of the hinge member 35 to the connecting member 37 may cause the divided cores 31, 32 to go away from each other, thus maintaining a state where the pair of divided cores 31, 32 are put around the electric wire 60, while bringing the corresponding ends of the divided cores, which are closed in a ring shape, into contact with each other. Even if the hinge member 35 of the current transformer is placed on the lower side of the electric wire 60, the hinge member bears its own weight (self-weight) so as to restrict the position of the hinge member relative to the connecting member 37, thus preventing an occurrence of motion of the divided cores 31, 32 in a direction in which they go away from each other.

The relative movement between the hinge member 35 and the connecting member 37, as well as the relative movement of the divided cores 31, 32 in directions in which the corresponding edges of the divided cores come into contact with each other position the supporting shafts 35d, 35e, which are integrally provided with the divided cores 31, 32, on the lower end side of the connection holes 35b, 35c (a position in which the connection holes 35b, 35c come close to each other in the closest position) of the hinge member main body 35a. Based on such a phenomenon, there may be provided a predetermined mechanism in which the movement of the supporting shafts 35d, 35e within the connection holes 35b, 35c may automatically be regulated when the supporting shafts 35d, 35e reach such positions, so as to maintain the positions of the supporting shafts 35d, 35e. In this case, in addition to advantages that unnecessary shift of the hinge member 35 relative to the connecting member 37 along with the shape of the connecting holes 35b, 35c as formed does not easily occur during an putting operation of the transformer, the divided cores 31, 32 with which the supporting shafts 35d, 35e are connected integrally are not allowed to move, thus making it possible to maintain strongly a state where the divided cores are closed in a ring shape. Further, once the divided cores are closed to bring the ends of the cores into contact with each other during an operation of setting the current transformer around the electric wire, the closed state of them is kept, with the result that connection of the closed divided cores does not loose even if an operator loses his/her hand on the transformer, so as to decrease the risk of drop of the transformer, thus improving an operation activity.

### [Fourth Embodiment of the Present Invention]

The current transformer according to the first and second embodiments as described above of the present invention has a structure in which the outer peripheral surface of the circular pillar-shaped portion of the outer cover body at the ends of the divided cores and the inner peripheral surface of the connecting member are formed as a curved surface shape on the outer periphery of a simple shape of a circular pillar or on the inner periphery of a simple shape of a circular tube. Alternatively, there may be applied a structure, as the fourth embodiment of the present invention, in which the circular pillar-shaped portions 44c of the outer cover bodies at the respective ends of the divided cores 41, 42 are provided on respective part of the outer peripheral surface with male screwed portions 44e in which respective thread-cutting directions of them are opposite to each other for the respective divided cores 41, 42, on the one hand, and each of the connecting members 47 is provided on respective part of the inner peripheral surface with two female screwed portions 47b in which respective thread-cutting directions of them are opposite to each other for the respective divided cores so as to receive the respective male screwed portions at the ends of the divided cores in a screwing manner, on the other hand, as shown in FIG. 14 to FIG. 16. In this case, for example, in a state where the connecting members 47 are put on the outer side at the ends of the one divided core 42 so as to be linearly movable and turnable (see FIG. 14), by inserting also the ends of the other divided core 41 into the respective connecting members 47 and causing the divided cores to come close to each other so that the male screwed-portions 44e of the circular pillar-shaped portions 44c of the outer cover bodies reach positions close to the female screwed portions 47b (see FIG. 15), and turning the connecting members 47 in a predetermined direction relative to the ends of the divided cores 41, 42, it is possible to cause a state where only a movement of the ends of the respective divided cores 41, 42 travelling into the connecting members 47 is allowed along with a screwing action between the male screwed portions 44e and the female screwed portions 47b, to bring the ends of the cores into contact with each other (see FIG. 16). Such a screwed state can be kept, unless the connecting members 47 are turned relative to the respective divided cores 41, 42 in the opposite direction to that as described above, so as to inhibit the ends of the divided cores 41, 42 from moving in a direction in which the ends of the divided cores are removed from the connecting members 47, thus maintaining surely the connection state between the ends of the divided cores.

### [Alternative Embodiment of the Present Invention]

The current transformer according to the first embodiment as described above of the present invention has a structure in which the hinge member 15 is designed so that the supporting shafts 15d, 15e, which are integrally provided with the respective divided cores 11, 12 are swingable and movable linearly, and the pair of divided cores 11, 12 are connected, while permitting, by the stationary connection of the pair of divided cores 11, 12 to these supporting shafts 15e, 15e of the hinge member, one of the pair of divided cores 11, 12, to swing relative to the other divided core and linearly move in a manner that the pair of divided cores come close to each other or go away from each other. The present invention is not limited only to such a structure, and there may be applied for example a structure in which the hinge member main body 55a of the hinge member 55 is composed of a plurality of sections in combination to provide a movable structure in which one of these sections 55b is swingable relative to the other section 55c, and the one divided core 51 is connected to the above-mentioned one section 55b of the hinge member main body 55a and the other divided core 52 is connected to the other section 55c, directly or via another movable member, so as to be linearly movable. Alternatively, there may be applied a structure in which the hinge member has a movable mechanism in which the one section of the hinge member main body is linearly movable relative to the other section, and one of the divided cores is swingably connected to the above-mentioned one section and the other divided core is connected to the above mentioned other section, directly or via another movable member as shown in FIG. 17 to FIG. 19. Each of these structures can also keep the pair of divided cores in a connected state where the pair of divided cores can be swung movable linearly relative to each other, and it is possible to carry out smoothly an opening and closing operation of the divided cores, when the pair of divided cores are put around the electric wire or cable, and insert smoothly the ends of the divided core into the connecting members and remove the ends of the divided cores from them, in the same manner as the embodiment as described of the present invention.

The current transformer according to the first embodiment as described above of the present invention has a structure in which the connecting member is designed as the circular tube, and accordingly the sealing body is designed as the circular ring-shaped body, and the edges of the outer cover body are also designed as the circular pillar. The present invention is not limited only to such a structure. There may be applied a structure in which the connecting member is designed in other tube shape than the circular tube, and the connecting member 57 is designed for example, as a rectangular tube as shown in FIG 20, and another shape may be applied to the ends of the sealing body and the outer cover body in accordance with such a shape of the connecting member. In addition, the tube shape of the connecting member is not limited only to such a circular tube body having the outer shape, which is similar to a cross-sectional shape of a bore portion on the inner side, but the connecting member may have a tube shape in which an inner shape defining a bore in cross section in the inside is different from an outer shape in cross section, and for example, the connecting member may have a circular cross section for the bore on the inner side and a square cross section on the outer side, as long as the end of the divided core can detachably inserted into the connecting member, and can receive the end of the connecting member, in case where the end of the outer cover body has the tube shape, or can receive the end of the outer cover body, in case where the end of the outer cover body has the pillar shape.

### [Reference Signs List]

- 1, 2: current transformer
- 11, 12, 21, 22: divided core
- 13, 23: coil
- 13a: lead line
- 14, 24, 27: outer cover body
- 14a, 24a: edge-cover part
- 14b, 24b, 27b: intermediate cover part
- 14c, 24c: circular pillar-shaped portion
- 14d, 14e, 24d: flange portion
- 14f: groove
- 15, 25: hinge member
- 15a: hinge member main body
- 15b, 15c: connection hole
- 15d, 15e: supporting shaft
- 16, 26: leading wire
- 11, 27a: connecting member
- 17a, 27a: groove
- 18, 18a, 28: sealing body
- 19, 29: tightening band
- 19a: bolt
- 19b: nut
- 27c: base portion
- 27d: circular tube shaped portion
- 31, 32: divided core
- 35: hinge member
- 35b, 35c: connection hole
- 37: connecting member
- 41, 42: divided core
- 44c: circular pillar-shaped portion
- 44e: male screwed portion
- 47: connecting member
- 47b: female screwed portion
- 51, 52: divided core
- 55: hinge member
- 55a: hinge member main body
- 55b: section
- 55c: other section
- 60: electric line

## Claims

1. A current transformer, which comprises a pair of divided cores having a shape of two halves into which a continuous substantially ring-shaped body is divided, a coil wound around one or both of the divided cores, and a hinge member that connects the pair of divided cores so as to be openable and closable, said current transformer being detachably put around an electric wire or cable so that the electric wire or cable passes through a bore portion, which is formed at a center of the pair of divided cores kept in a closed state into a substantially ring-shape, said current transformer further comprises:
an outer cover body that covers an outer peripheral portion, excepting opposite ends of each of the pair of the divided cores, which face each other, and said coil to insulate them from outside, said outer cover body being formed of material having a waterproof property and an insulation property;
two connecting members each formed as a tube body, into which corresponding one ends of the divided cores and other ends of them are to be inserted detachably to connect them with each other; and
a sealing body being formed of elastic material into a ring-shape, said sealing body being provided on the connecting members or the outer cover body, in a state where the ends of each of the divided cores are inserted into the connecting members, respectively, so as to be placed between an inner peripheral portion of the connecting member and an outer peripheral portion of an end of the outer cover body, which is inserted into the connecting member to be placed inside of the connecting member, or between an outer peripheral portion of the connecting member and an inner peripheral portion of the end of the outer cover body having a tube shape into which the end of the connecting member is inserted to be placed outside of the connecting member;
wherein:
ends of said outer cover body in a vicinity of the opposite ends of the divided core have a pillar shape having an outer shape, which is similar to a cross-sectional shape of an opening of an inside of the tube body of the connecting member into which the end portion of the divided core is to be inserted, or have a tube shape having an opening shape, which is similar to a cross-sectional shape of an outer tube shape of the connecting member into which the end portion of the divided core is to be inserted;
both ends having the pillar shape or the tube shape of said outer cover body are shaped so that the pillar shape or the tube shape extend parallel with each other;
said hinge member is connected to each of the divided cores so that the pair of divided cores cause extending directions of the ends of the outer cover body to align to permit a linear relative movement in which the pair of divided cores come close to each other or go away from each other; and
the ends of the each of the divided cores are inserted into each of the connecting members in a state where the pair of divided cores are closed in a substantial ring-shape, and in such a closed state the ends of the divided cores come into contact with each other and said sealing body come into close contact with each of the connecting members and the outer cover body without creating a gap therebetween, with elastic deformation of the sealing body.

2. A current transformer, which comprises a pair of divided cores having a shape of two halves into which a continuous substantially ring-shaped body is divided, a coil wound around one or both of the divided cores, and a hinge member that connects the pair of divided cores so as to be openable and closable, said current transformer being detachably put around an electric wire or cable so that the electric wire or cable passes through a bore portion, which is formed at a center of the pair of divided cores kept in a closed state into a substantially ring-shape, said current transformer further comprises:
an outer cover body that covers an outer peripheral portion, excepting opposite ends of each of the pair of the divided cores, which face each other, and said coil to insulate them from outside, said outer cover body being formed of material having a waterproof property and an insulation property;
two connecting members provided on opposite ends of one of said divided cores, respectively, each of the two connecting members having a tube portion, one end of the other of the divided cores being inserted detachably into the tube portion of the one of the divided cores and an other end of the other of the divided cores being inserted detachably into the other tube portion of the one of the divided cores, to connect them with each other; and
a sealing body being formed of elastic material into a ring-shape, said sealing body being provided on the connecting members or the outer cover body, in a state where the ends of the other of the divided cores are inserted into the connecting members, respectively, so as to be placed between an inner peripheral portion of the connecting member and an outer peripheral portion of an end of the outer cover body, which is inserted into the connecting member to be placed inside of the connecting member, or between an outer peripheral portion of the connecting member and an inner peripheral portion of the end of the outer cover body having a tube shape into which the end of the connecting member is inserted to be placed outside of the connecting member;
wherein:
said two connecting members are provided so that each of the ends of the one of the divided cores is placed in the tube portion and the tube shape extend parallel with each other;
ends of said outer cover body for the other of the divided cores in a vicinity of the opposite ends of the divided core have a pillar shape having an outer shape, which is similar to a cross-sectional shape of an opening of an inside of the tube body of the connecting member into which the end portion of the divided core is to be inserted, or have a tube shape having an opening shape, which is similar to a cross-sectional shape of an outer tube shape of the connecting member into which the end portion of the divided core is to be inserted;
both ends having the pillar shape or the tube shape of said outer cover body for the other of the divided cores are shaped so that the pillar shape or the tube shape extend parallel with each other;
said hinge member is connected to each of the divided cores so that the pair of divided cores cause extending directions of the connecting member and extending directions of the ends of the outer cover body to align to permit a linear relative movement in which the pair of divided cores come close to each other or go away from each other; and
each of the ends of the other of the divided cores are inserted into each of the connecting members in a state where the pair of divided cores are closed in a substantial ring-shape, and in such a closed state the ends of the divided cores come into contact with each other and said sealing body come into close contact with each of the connecting members and the outer cover body without creating a gap therebetween, with elastic deformation of the sealing body.

3. A current transformer, which comprises a pair of divided cores having a shape of two halves into which a continuous substantially ring-shaped body is divided, a coil wound around one or both of the divided cores, and a hinge member that connects the pair of divided cores so as to be openable and closable, said current transformer being detachably put around an electric wire or cable so that the electric wire or cable passes through a bore portion, which is formed at a center of the pair of divided cores kept in a closed state into a substantially ring-shape, said current transformer further comprises:
an outer cover body that covers an outer peripheral portion, excepting opposite ends of each of the pair of the divided cores, which face each other, and said coil to insulate them from outside, said outer cover body being formed of material having a waterproof property and an insulation property;
two connecting members provided on one end of one of the divided cores and other end of the other of the divided cores, respectively, each of the two connecting members having tube portion, one end of the other of the divided cores being inserted detachably into the tube portion at the one end of one of the divided cores and other end of the other of the divided cores being inserted detachably into the other tube portion at the other end of the other of the divided cores, to connect them with each other;
a sealing body being formed of elastic material into a ring-shape, said sealing body being provided on the connecting members or the outer cover body, in a state where the ends of each of the divided cores are inserted into the connecting members, respectively, so as to be placed between an inner peripheral portion of the connecting member and an outer peripheral portion of an end of the outer cover body, which is inserted into the connecting member to be placed inside of the connecting member, or between an outer peripheral portion of the connecting member and an inner peripheral portion of the end of the outer cover body having a tube shape into which the end of the connecting member is inserted to be placed outside of the connecting member;
wherein:
ends of said outer cover body for each of the divided cores in a vicinity of the end of the divided core on a side where the connecting member is not provided have a pillar shape having an outer shape, which is similar to a cross-sectional shape of an opening of an inside of the tube body of the connecting member into which the end portion of the divided core is to be inserted, or have a tube shape having an opening shape, which is similar to a cross-sectional shape of an outer tube shape of the connecting member into which the end portion of the divided core is to be inserted;
ends having the pillar shape or the tube shape of said outer cover body for the divided cores are shaped so that the pillar shape or the tube shape extend parallel with the tube shape of the connecting member provided on a same divided core;
said hinge member is connected to each of the divided cores so that the pair of divided cores cause extending directions of the connecting member and extending directions of the ends of the outer cover body to align to permit a linear relative movement in which the pair of divided cores come close to each other or go away from each other; and
end of the other of the divided cores is inserted into the connecting members of each of the divided cores in a state where the pair of divided cores are closed in a substantial ring-shape, and in such a closed state the ends of the divided cores come into contact with each other and said sealing body come into close contact with each of the connecting members and the outer cover body without creating a gap therebetween, with elastic deformation of the sealing body.

4. The current transformer as claimed in any one of claims 1 to 3, wherein:
said hinge member comprises a hinge member main body provided with a connection hole as an elongated hole having a predetermined length; and a supporting shaft, which is inserted into said connection hole so as to be movable in a longitudinal direction thereof and swingable, one or a plurality of sets of said connection hole and said supporting shaft being provided for said hinge member main body; and
at least one divided core of the pair of divided cores and said hinge member are connected to each other so that the supporting shaft of said hinge member is connected to a predetermined position of the outer cover body, with which said divided core is covered, on a side of the end of the divided core, and said divided core connected to said supporting shaft is movable and swingable relative to said hinge member main body.

5. The current transformer as claimed in any one of claims 1 to 4, wherein:
said outer cover body comprises an intermediate portion placed between the ends or the connecting members provided on the opposite ends in the pillar shape or the tube shape, said intermediate portion being separately formed from the ends or the connecting members provided on the opposite ends in the pillar shape or the tube shape, and the intermediate portion is formed through a resin molding after mounting parts for forming the ends or the connecting members provided on the opposite ends in the pillar shape or the tube shape to the opposite ends of the divided core.

6. The current transformer as claimed in any one of claims 1 to 5, further comprising:
a fastening member detachably provided in a vicinity of the divided cores so as to be capable of pressing the pair of divided cores to each other from outside in a direction in which the pair of divided cores come close to each other in a state where the ends of the divided cores are inserted together with the outer cover body into said connecting members to keep a closed state of the pair of divided cores in a substantially ring-shape, so as to keep a close contact state between the one ends of the pair of divided cores and between the other ends thereof.

7. A current transformer, which comprises a pair of divided cores having a shape of two halves into which a continuous substantially ring-shaped body is divided, a coil wound around one or both of the divided cores, and a hinge member that supports the pair of divided cores so as to be openable and closable, said current transformer being detachably put around an electric wire or cable so that the electric wire or cable passes through a bore portion, which is formed at a center of the pair of divided cores kept in a closed state into a substantially ring-shape, said current transformer further comprises:
a fastening member detachably provided in a vicinity of the divided cores so as to be capable of pressing the pair of divided cores to each other from outside in a direction in which the pair of divided cores come close to each other in a state where the pair of divided cores is kept in a closed state in a substantially ring-shape, so as to keep a close contact state between the one ends of the pair of divided cores and between the other ends thereof; and
said hinge member is connected to each of the divided cores so that the pair of divided cores causes the one ends and the other ends of the pair of divided cores to face each other to permit a linear relative movement in which the pair of divided cores come close to each other or go away from each other.
